(19) Europäisches Patentamt
European Patent Office
Office européen des brevets

(11) **EP 0 415 853 B1**

## (12) EUROPEAN PATENT SPECIFICATION

(45) Date of publication and mention
of the grant of the patent:
**19.11.1997 Bulletin 1997/47**

(51) Int Cl.6: **G11B 20/14**, G11B 20/18,
H03M 13/00

(21) Application number: **90402414.8**

(22) Date of filing: **31.08.1990**

(54) **Digital data transmission system having error detecting and correcting function**

Digitales Datenübertragungssystem mit Fehlererkennung und Fehlerkorrektur

Système de transmission de données numériques avec détection et correction d'erreur

(84) Designated Contracting States:
**DE FR GB**

(30) Priority: **31.08.1989 JP 225855/89**

(43) Date of publication of application:
**06.03.1991 Bulletin 1991/10**

(73) Proprietor: **SONY CORPORATION**
**Tokyo 141 (JP)**

(72) Inventors:
 • **Suzuki, Hideto**
   **Shinagawa-ku, Tokyo (JP)**
 • **Kurose, Yoshikazu**
   **Shinagawa-ku, Tokyo (JP)**
 • **Aoki, Shinji**
   **Shinagawa-ku, Tokyo (JP)**

(74) Representative: **Thévenet, Jean-Bruno et al**
**Cabinet Beau de Loménie**
**158, rue de l'Université**
**75340 Paris Cédex 07 (FR)**

(56) References cited:
**GB-A- 2 201 067**

 • **PATENT ABSTRACTS OF JAPAN vol. 9, no. 113**
   **(P-356)17 May 1985 & JP-A-60 000 669**
 • **PATENT ABSTRACTS OF JAPAN vol. 10, no. 113**
   **(E-399)26 April 1986 & JP-A-60 248 025**

Remarks:
The file contains technical information submitted after the application was filed and not included in this specification

## Description

BACKGROUND OF THE INVENTION

1. Field of the Invention

This invention relates to a digital data transmission system wherein an error correction code of the product sign format is added to data to be transmitted to effect error correcting processing and NRZL-NRZI conversion is made for data to be transmitted.

2. Description of the Prior Art

Conventionally, a data recorder conforming to the ANSI ID-1 format (Third Draft PROPOSED AMERICAN NATIONAL STANDARD 19 mm TYPE ID-1 INSTRUMENTATION DIGITAL CASSETTE FORMAT X3B6/88-12 Project 592-D 1988-03-22) is known as a recording and reproducing device which records information data in a high density.

In such a data recorder, processing proceeds such that an error correction code of the product sign format employing a Reed-Solomon code is added to information data and such information data are recorded onto a magnetic tape, and then upon reproduction, an error in transmission is detected to correct the same.

Such a data recorder will be described below in outline.

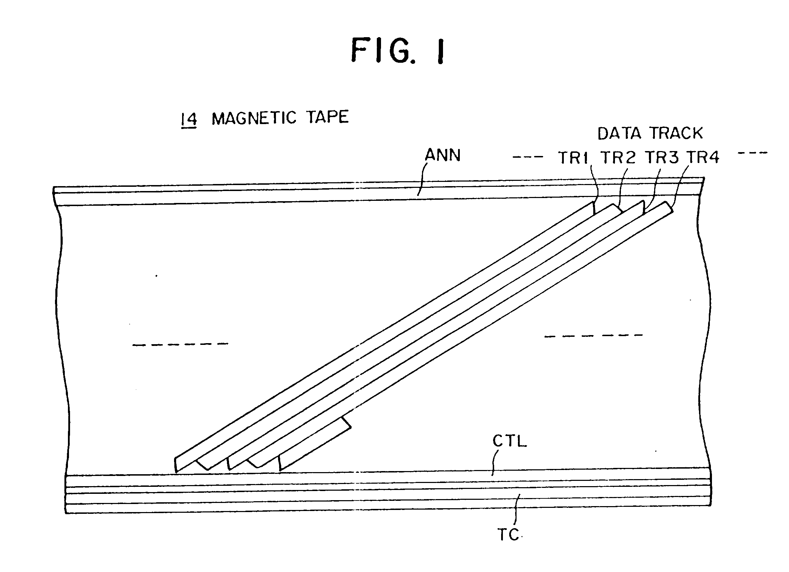

Referring first to FIG. 1, there is shown a record pattern which is recorded on a magnetic tape by means of a data recorder which conforms to the ID-1 format. The record pattern shown includes an annotation track ANN on which annotations are recorded. The record pattern further includes data tracks TR1, TR2, TR3, ... on which information data are recorded with one sector formed on each track. It is to be noted that the individual data tracks are azimuth recorded in an alternate relationship. The record pattern further includes a control track CTL on which control signals are recorded, and a time code track TC on which time codes are recorded.

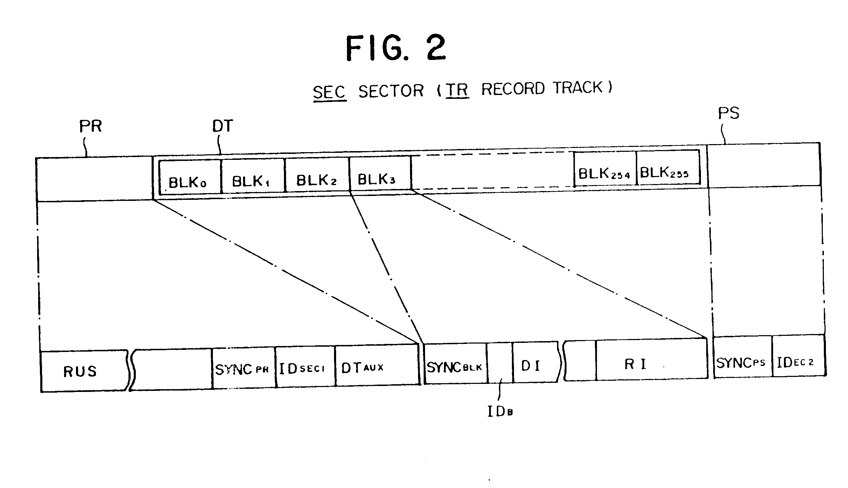

By the way, construction of the data tracks TR1, TR2, TR3, ... is prescribed commonly to the individual tracks in such a manner as illustrated in FIG. 2. In particular, each one of the data tracks TR corresponds to one sector SEC and is formed from a preamble portion PR, a data record portion DT and a postamble portion PS. It is to be noted that the preamble portion PR corresponds to a lower side head portion of a data track which is formed in an inclined relationship on the magnetic tape.

The preamble portion PR is formed from a rising sequence RUS having the length of 20 bytes, a synchronization code $SYNC_{PR}$ and sector identification data $ID_{SEC1}$ both having the length of 4 bytes, and auxiliary data $DT_{AUX}$ having the length of 6 bytes.

Meanwhile, the subsequent data record portion DT consists of 256 synchronization blocks BLK ($BLK_{\emptyset}$, $BLK_1$, $BLK_2$, .... and $BLK_{256}$), and information data inputted is recorded on the data record portion DT. Each of the synchronization blocks BLK is formed from a block synchronization code $SYNC_{BLK}$ having the length of 4 bytes, block identification data $ID_B$ having the length of one byte, inner data (data obtained by inner decoding of input information data) DI having the length of 153 bytes, and a parity code RI in the form of a Reed-Solomon code having the length of 8 bytes.

The further following postamble portion PS is formed from a synchronization code $SYNC_{PS}$ and sector identification data $ID_{SEC2}$ both having the length of 4 bytes.

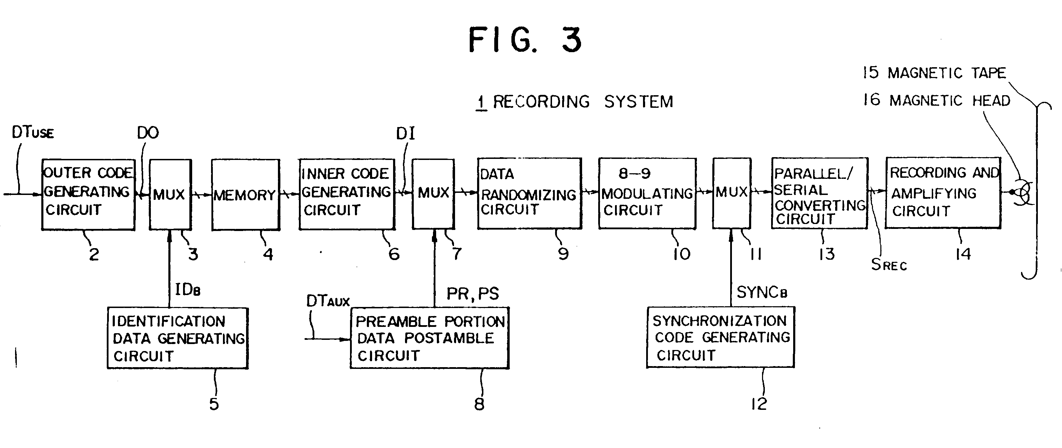

Referring now to FIG. 3, there is shown a recording system of a data recorder of the ID-1 format. In the recording system 1, an error correction code of the product sign format is added to input information data, and the information data thus obtained is recorded onto a magnetic tape.

Operation of individual component circuits of the recording system 1 is such as follows.

First, information data $DT_{USE}$ of a construction wherein 8 bits make one byte are first inputted to an outer code generating circuit 2.

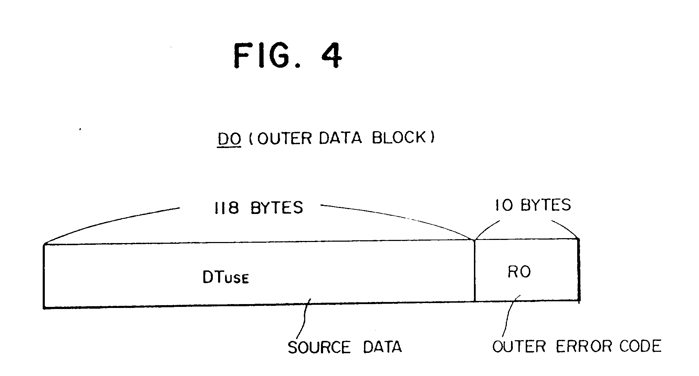

The outer code generating circuit 2 produces as outer codes parity codes $RO_{\emptyset}$ to $RO_{3\emptyset5}$ each formed from 10 bytes in the form of a Reed-Solomon code for the individual data blocks of the input information data $DT_{USE}$ which each include 118 bytes as a unit using a predetermined generating function, and then adds the outer codes to the ends of the individual blocks as shown in FIG. 4 and outputs them as outer data blocks DO. The outer data blocks DO are transmitted to a memory 4 by way of a first multiplexer 3.

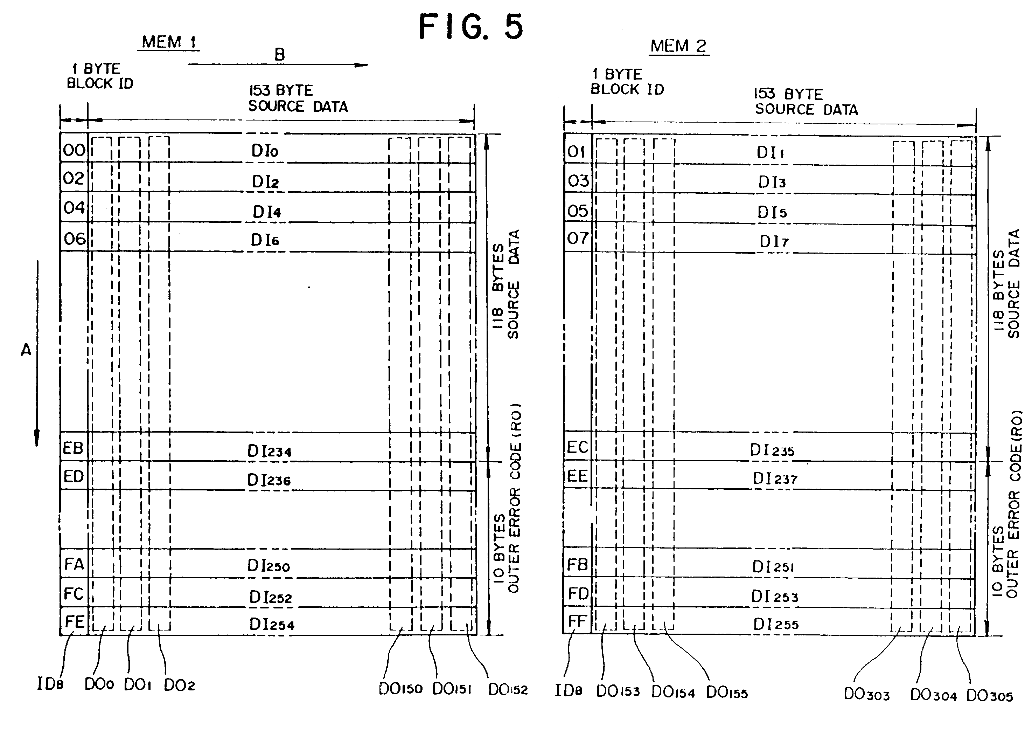

Construction of the memory 4 and an array of data in the memory 4 are illustrated in FIG. 5. As shown in FIG. 5, the memory 4 includes two memories MEM1 and MEM2 wherein each row includes 154 bytes while each column includes 128 bytes. Outer data blocks $DO_{\emptyset}$ to $DO_{162}$ for 153 blocks successively inputted to the memory 4 are written into the memory MEM1 while outer data blocks $DO_{153}$ to $DO_{3\emptyset6}$ for 153 blocks successively inputted to the memory 4 subsequently are written into the other memory MEM2, each by one outer data block for one row. Since information data of one outer data block consist of 118 bytes and information data for 153 blocks are written into each of the memories MEM1 and MEM2, the memory 4 stores information data of 118 x 153 x2 bytes, that is, 36, 108 bytes therein.

The order of writing of data in each column of the memories MEM1 and MEM2 is such as indicated by an arrow mark A in FIG. 5, and each lower side 10 bytes in the memories MEM1 and MEM2 corresponds to an outer code.

Data block identification data $ID_B$ which are generated by an identification data generating circuit 5 and serve as data for the identification of each row in the memories MEM1 and MEM2 are also transmitted to the memory 4 by way of the first multiplexer circuit 3. Of the data block identification data $ID_B$, even-numbered ones $ID_{BE}$ and odd-numbered ones $ID_{BO}$ are written in the direction indicated by the arrow mark A column by column into the memories MEM1 and MEM2, respectively.

Data written in the memories MEM1 and MEM2 are read out in an order indicated by an arrow mark B along the columns block by block provided by data of one column. Reading out of the individual columns are executed alternately from the memories MEM1 and MEM2 in an order conforming to the data block identification data $ID_B$ (00, 01, 02, 03, ...).

Data read out from the memories MEM1 and MEM2 are inputted to an inner code generating circuit 6.

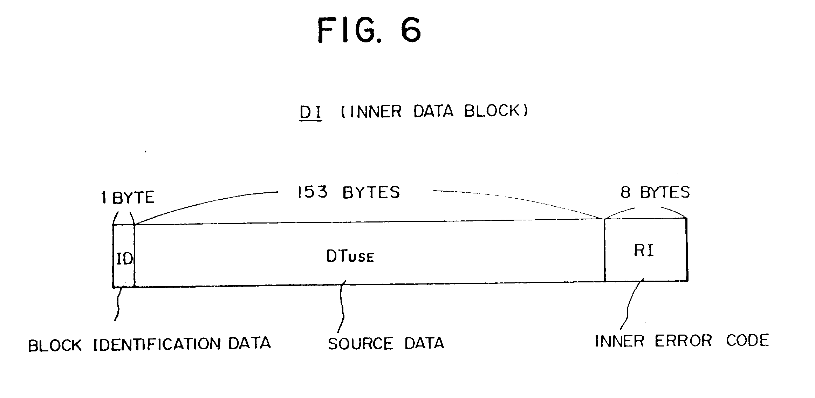

The inner code generating circuit 6 generates as inner codes parity codes $RI_0$ to $RI_{255}$ each formed from 8 bytes in the form of a Reed-Solomon code for the individual inner data blocks inputted thereto using a predetermined generating function, and adds the inner codes to the ends of the individual data blocks and outputs them as such inner data blocks $DI_0$ to $DI_{255}$ as shown in FIG. 6 to a second multiplexer 7.

The second multiplexer circuit 7 successively selects and outputs preamble data PR and postamble data PS produced from a preamble portion and postamble portion generating circuit 8 and inner data blocks $DI_0$ to $DI_{255}$ outputted from the inner code generating circuit 6. The order of output data is: preamble data PR, inner data block $DI_0$ to $DI_{255}$ and postamble data PS.

Output of the second multiplexer circuit 7 is inputted to a data randomizer 9.

The data randomizer 9 exclusive ORs each one byte of data inputted thereto and predetermined data to randomize the data.

Such randomized data are inputted to an 8-9 modulating circuit 10.

The 8-9 modulating circuit 10 converts construction of data from 8 bits into 9 bits in order to remove a dc component from (to dc free) a waveform of a signal to be recorded onto a magnetic tape. The conversion is such as follows in outline.

In particular, 9-bit data of two kinds are defined in prior for each value of input data of 8 bits for one byte having 256 different values in accordance with the ID-I format. Those 9-bit data of two kinds are such data wherein the CDS (Codeword Digital Sum) is different from each other in sign between positive and negative. The 8-9 modulating circuit 10 monitors the DSV (Digital Sum Variation) of 9-bit data outputted in response to input data and selects one of 9-bit data of the two kinds having different values of the CDS so that the value of the DSV may converge to zero. Input data of the construction wherein 8 bits make one byte are converted into dc free data of 9-bit construction in this manner.

It is to be noted that the 8-9 modulating circuit 10 includes a circuit for converting the format of input data of NRZL (Non-Return-to-Zero-Level) into NRZI (Non-Return-to--Zero-Inverse) data.

An output of the 8-9 modulating circuit 10, that is, NRZI data of the 9-bit construction, are inputted to a third multiplexer circuit 11.

The Third multiplexer circuit 11 adds to each of the inner data blocks $DI_0$ to $DI_{255}$ a fixed synchronization code $SYNC_B$ of the length of 4 bytes formed from a synchronization code generating circuit 12 to form a synchronization block $BLK_0$ to $BLK_{256}$. A code pattern of the synchronization code $SYNC_B$ is prescribed in the ID-1 format, and it is also prescribed that a pattern recorded on a magnetic tape must maintain such code pattern.

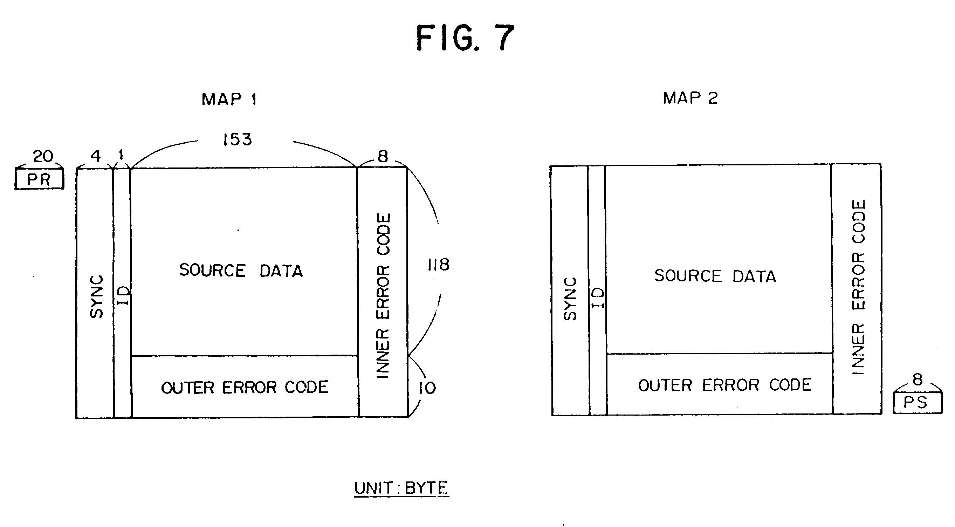

Data obtained by such processing as described above can be indicated in such maps as shown in FIG. 7. An output of the third multiplexer circuit 11 provides a data array which is obtained by scanning the maps MAP1 and MAP2 in a horizontal direction. Details of the data array are such as shown in FIG. 2.

The output of the third multiplexer circuit 11 is inputted to a parallel/serial converting circuit 13.

The parallel/serial converting circuit 13 converts data of the preamble portion PR, synchronization blocks $BLK_0$ to $BLK_{255}$ and postamble portion PS of the bit parallel construction inputted thereto into data $S_{REC}$ of the bit serial construction.

The serial data $S_{REC}$ are amplified by a recording and amplifying circuit 14 and then supplied as a recording signal to a magnetic head 16 which scans on a magnetic tape 15 to record the signal onto the magnetic tape 15. Consequently, such data tracks TR (..., TR1, TR2, TR3, TR4, ...) as shown in FIG. 1 are formed on the magnetic tape 15.

In this manner, the recording system 1 of the data recorder is constituted such that it adds an error correction code to desired information data $DT_{USE}$ in accordance with the Reed-Solomon product sign format to record the same.

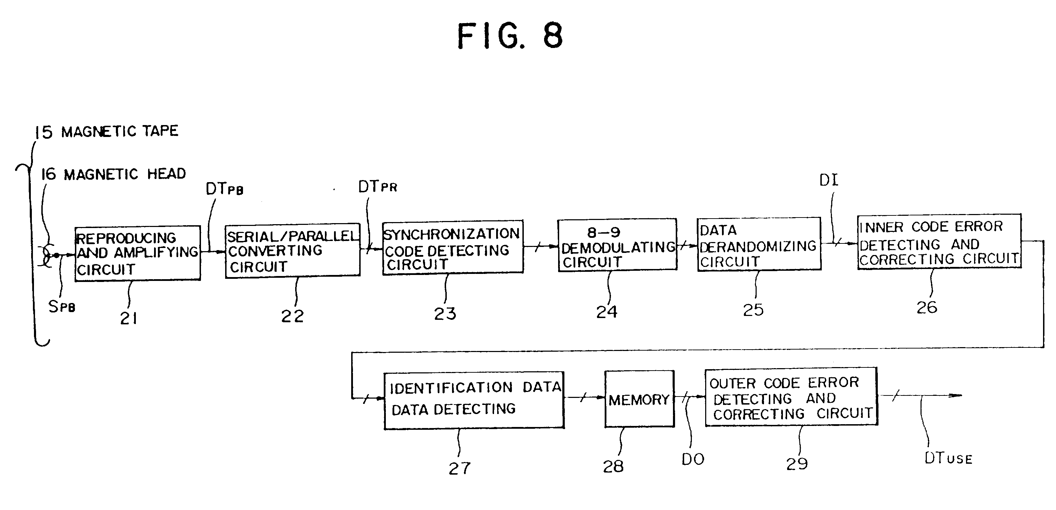

Meanwhile, the information data $DT_{USE}$ recorded on the magnetic tape 14 by the recording system 1 of the data recorder in this manner are reproduced by a reproducing system 20 of the data recorder shown in FIG. 8.

The reproducing system 20 executes signal processing substantially reverse to that executed by the recording system 1.

In particular, in the reproducing system 20 of the data recorder, record tracks TR (..., TR1, TR2, TR3, TR4, ...) on a magnetic tape 15 are read out as a reproduction signal $S_{PB}$ using a magnetic head 16 and inputted to a reproducing amplifying circuit 21.

The reproducing amplifying circuit 21 is constructed including an equalizer, a binary digitizing circuit and so forth and binary digitizes a reproduction signal $S_{PB}$ inputted thereto into reproduction digital data $DT_{PB}$ which are outputted to a succeeding serial/parallel converting circuit 22.

The serial/parallel converting circuit 22 converts the reproduction digital data $DT_{PB}$ of the serial type into 9-bit parallel data $DT_{PR}$.

A synchronization code detecting circuit 23 detects a synchronization code $SYNC_B$ from a flow of the parallel data $DT_{PR}$ and identifies a synchronization block in accordance with such synchronization code $SYNC_B$. The synchronization code detecting circuit 23 includes a circuit for converting parallel data $DT_{PR}$ of the NRZI format into those of the NRZL format.

An output of the synchronization code detecting circuit 23 is inputted to an 8-9 demodulating circuit 24. The 8-9 demodulating circuit 24 demodulates data which have been converted from 8-bit data into 9-bit data for the dc freeing back into 8-bit data. The 8-9 demodulating circuit 24 is constituted from a ROM (Read Only Memory) and converts data from 9 bits into 8 bits by map retrieving processing.

Data demodulated into 8 bits are derandomized by a derandomizer 25 reversely to the randomizing processing which has been executed by the recording system 1. Such derandomization is accomplished by exclusive ORing of input data to the derandomizer 25 and the same predetermined data as have been used for the randomizing processing.

An inner code error detecting circuit 26 executes error detection and correction using inner codes $RI_0$ to $RI_{255}$ of the length of 8 bytes added to the individual inner data blocks $DI_0$ to $DI_{255}$ among the identified synchronization blocks.

The inner data blocks $DI_0$ to $DI_{255}$ after such inner code error correction are written into a memory 28 having the same construction as the memory 4 of the recording system 1 shown in FIG. 5 in accordance with block identification data $ID_B$ added to the individual blocks and detected by an identification data detecting circuit 27 such that each data block may make a row. The order of writing is similar to the order of reading out from the memory 4 of the recording system 1, and writing is executed for each row alternately into the memories MEM1 and MEM2 along the block identification data.

Data written in the memories MEM1 and MEM2 of the memory 28 are subsequently read out in the column direction in the same order as the order of writing of the memory 4 of the recording system 1. As a result, outer data blocks $DO_0$ to $DO_{305}$ the length of 128 bytes are obtained again.

An outer code error detecting and correcting circuit 29 executes error detection and correction using outer codes $RO_0$ to $RO_{305}$ added to the individual outer data blocks $DO_0$ to $DO_{305}$ outputted from the memory 28.

Information data $DT_{USE}$ recorded on the magnetic tape 15 are reproduced in this manner.

By the way, the data recorder having such a construction as described above has the following problems in actually receiving information data and recording and reproducing such information data. Accordingly, it is difficult to obtain a data recorder of a high degree of accuracy.

In particular, such 8-9 modulating circuit as is used with the recording system 1 of the data recorder of the construction described above is disclosed in U.S. Patent No. 4,520,346 and is generally constituted in such a manner as shown in FIG. 9.

In particular, in the 8-9 modulating circuit 10, input data $DT_{NRZL}$ in the form of an NRZL (non-return-to-zero-level) code of 8 bits are inputted to a code converting circuit 102 and a CDS (Codeword Digital Sum) converting circuit 103 by way of an input register circuit 101.

The code converting circuit 102 has a construction of a ROM (read only memory) in which contents of a code conversion table (Table 3 Randomized 8-bit Byte to 9-bit NRZL Word Mapping (pages 15 to 20)) specified in the ID-I format are stored, and code word data $DT_{CODE}$ obtained by conversion of input data $DT_{NRZL}$ into an NRZL code of 9 bits are read out from a memory address of the code converting circuit 102 corresponding to input data $DT_{NRZL}$ and a CDS selection signal $C_{CDS}$ inputted thereto from a controlling circuit 104.

The code word data $DT_{CODE}$ are once converted into serial data $S_{CODE}$ by means of a serial to parallel converting circuit 105 and then inputted to an NRZL/NRZI (non-return-to-zero-level/non-return-to-zero-inverse) converting circuit 106 at which they are NRZL/NRZI converted, and serial output data $S_{NRZI}$ in the form of an NRZI code are sent out from the NRZL/NRZI converting circuit 106.

Meanwhile, the CDS converting circuit 103 has a construction of a ROM in which contents of a CDS conversion table (Table 3 Randomized 8-bit Byte to 9-bit NRZL Word Mapping (pages 15 to 20)) specified in the ID-1 format are stored similarly to the code converting circuit 102, and CDS data $D_{CDS}$ are read out from a memory address of the CDS converting circuit 103 corresponding to input data $DT_{NRZL}$ and a CDS selection signal $C_{CDS}$ inputted thereto from the controlling circuit 104. The CDS data $D_{CDS}$ thus read out are sent out to an adding/subtracting circuit 107.

The adding/subtracting circuit 107 adds or subtracts CDS data $D_{CDS}$ to or from DSV (Digital Sum Variation) data $D_{DSV}$ in response to an addition/subtraction controlling signal $C_{AS}$ inputted thereto from the controlling circuit 104, and a result of such calculation is added cumulatively at an accumulator circuit 108. Then, DSV data $D_{DSV}$ obtained by such cumulative addition are inputted from the accumulator circuit 108 to the adding/subtracting circuit 107.

Meanwhile, inputted to the controlling circuit 104 are a CDS signal $S_{CDS}$ sent out from the CDS converting circuit 103, a DSV signal $S_{DSV}$ in the form of a code bit of DSV data $D_{DSV}$ sent out from the accumulator circuit 108 and a last bit signal $S_{NRZI}$ of one code word data $DT_{CODE}$ after NRZL/NRZI conversion by the NRZL/NRZI converting circuit 106. Then, the controlling circuit 104 sends out a CDS selection signal $C_{CDS}$ for the code converting circuit 102 and the CDS converting circuit 103 in accordance with a method specified in a control table (Table 4 9-bit NRZL Word Selection (page 21). Table 5 DSV Calculation Using Preamble Run-up and Sync Pattern (page 22)) of the ID-1 format. The controlling circuit 104 further sends out an addition/subtraction controlling signal $C_{AS}$ for the adding/subtracting circuit 107.

It is to be noted that, in the present 8-9 modulating circuit 10, a reset signal $S_{RST}$ is inputted to the controlling circuit 104 and the accumulator circuit 108 so that the entire 8-9 modulating circuit 10 may be initialized for each one sector SEC.

By the way, practically in the ID-I format, magnetization patterns of the rising sequence RUS of the preamble portion PR, the synchronization codes $SYNC_{PR}$ and $SYNC_{PS}$ of the preamble portion PR and postamble portion PS and the block synchronization code $SYNC_{BLK}$ of the synchronization block BLK are specified individually including their polarities.

In particular, the rising sequence RUS of the preamble portion PR is specified to a magnetization pattern which consists of 10 repeats of a symbol of 18 bits of "001110001 110001110" as represented as "001110001 110001110 ... 001110001 110001110" in order from the LS3 (least significant bit) while the synchronization codes $SYNC_{PR}$ and $SYNC_{PS}$ of the preamble portion PR and postamble portion PS are specified to another magnetization pattern represented by "000011001 111111110 010111000 000001101" in order from the LSB, and the block synchronization code $SYNC_{BLK}$ of the synchronization block BLK is specified to a further magnetization pattern represented by "111100110 000000001 101000111 111110010" in order from the LSB (5.4 Helical Record Content, Format, Synchronization, and Recording Method (pages 7 to 11)).

By the way, in the 8-9 modulating circuit 10 having such circuit construction as described above, the polarity of serial output data $DT_{NRZI}$ obtained by NRZL/NRZI conversion of input data $DT_{NRZL}$ is specified by the polarity of the last bit $S_{NRZI}$ of serial output data $DT_{NRZI}$ immediately preceding to the serial output data. Accordingly, there is a problem that the synchronization code $SYNC_{PR}$ or $SYNC_{PS}$ or the block synchronization code $SYNC_{BLK}$ cannot be recorded with a specified magnetization pattern.

Consequently, while, in the recording system 1 of the data recorder, a synchronization code $SYNC_{PR}$ or $SYNC_{PS}$ or a block synchronization code $SYNC_{BLK}$ sent out from the synchronization code generating circuit 12 is combined at a predetermined timing with data after 8-9 modulation set out from the 8-9 modulating circuit 10, according to such construction, there is another problem that data after NRZL/NRZI conversion become indefinite in polarity and cannot be reproduced by a reproducing system.

On the other hand, the inner code detecting and correcting circuit 26 of the reproducing system 20 of the data recorder actually operates in the following manner. In particular, identification data $ID_B$, synchronization block data $DT_{BLK}$ and a parity code RI are written in this order into an address corresponding to each of identification data $ID_B$ of those synchronization blocks BLK which are free from an error or errors of which have been corrected. On the other hand, only an inner code error flag $FLG_{IN}$ is added to each of those synchronization blocks BLK which cannot be corrected to eliminate an error while writing of such synchronization blocks BLK into the memory is suspended.

In the meantime, the outer code error detecting and correcting circuit 29 successively reads the two memories 28, into which an output of the inner code error detecting and correcting circuit 26 has been written, for each 128 bytes in the column direction and executes error detection and correction processing using an outer code. Information data $DT_{USE}$ recorded are reproduced in this manner.

By the way, if it is controlled as in the reproducing system 20 of the data recorder of such construction as described above such that writing into the memory of a synchronization block BLK for which an error cannot be corrected is suspended by the inner code error detecting and correcting circuit 26, then in case an error takes place at a portion other than the synchronization block data $DT_{BLK}$, that is, at the synchronization code $SYNC_{BLK}$, identification data $ID_B$ or parity code RI and this makes correction of an error impossible, the synchronization block data $DT_{BLK}$ which are not actually in error will not be written into the memory either. Consequently, the correct synchronization block data $DT_{BLK}$ cannot be sent to the outer code error detecting and correcting circuit 29. As a result, there is a problem that the outer code error detecting and correcting circuit 29 may also make correction of an error impossible.

Meanwhile, in case the inner code error detecting and correcting circuit 26 corrects an error of a synchronization block BLK in error and the identification data $ID_B$ of the synchronization block BLK are in error, the synchronization block BLK is written as a correct synchronization block BLK into a wrong memory address. Accordingly, there is a problem that, in case the outer code error detecting and correcting circuit 29 executes an erasure calculation as a result, further correction will take place in error.

Also in case data of all "0" are inputted, due to a cause of a dropout on the magnetic tape 15 or the like, for a synchronization block BLK wherein the identification data $ID_B$ have a value other than "00", a synchronization block BLK of all "0" is written as correct data into an address of the memory for which the identification data $ID_B$ have the value "00". Accordingly, there is a problem that, if the outer code error detecting and correcting circuit 29 makes an erasure calculation, further correction will take place in error similarly as described above.

SUMMARY OF THE INVENTION

It is an object of the present invention to provide a data transmission system, as defined in claim 1, which can effect dc free NRZL/NRZI conversion of data wherein prescribed data are included in part of a magnetization pattern.

It is another object of the present invention to provide a magnetic recording and (optionally) reproducing device, as defined in claim 11, which can record and reproduce input information data accurately, on the basis of an NRZL/NRZI conversion of data wherein prescribed data are included in part of a magnetization pattern.

It is a further object of the present invention to provide a magnetic recording and reproducing device which is significantly improved in error correction efficiency and accuracy.

The above and other objects, features and advantages of the present invention will become apparent from the following description and the appended claims, taken in conjunction with the accompanying drawings in which like parts are denoted by like reference characters all through the drawings.

BRIEF DESCRIPTION OF THE DRAWINGS

FIG. 1 is a diagrammatic view illustrating a record pattern recorded on a magnetic tape conforming to the ID-1 format;
FIG. 2 is a diagrammatic view illustrating contents of a record track of the record pattern shown in FIG. 1;
FIG. 3 is a block diagram showing general construction of a recording system of a conventional data recorder;
FIG. 4 is a diagrammatic view illustrating construction of output data of an outer code generating circuit of the recording system of FIG. 3;
FIG. 5 is a diagrammatic view illustratively showing construction of a memory of the recording system of FIG. 3;
FIG. 6 is a diagrammatic view illustrating construction of output data of an inner code generating circuit of the recording system of FIG. 3;
FIG. 7 is a diagrammatic view showing data maps for data to be processed by the recording system of FIG. 3;
FIG. 8 is a block diagram showing general construction of a reproducing system of the conventional data recorder;
FIG. 9 is a block diagram showing general construction of a conventional 8-9 modulating circuit employed in the recording system of FIG. 3;
FIG. 10 is a block diagram of an 8-9 modulating circuit to which the present invention is applied;
FIG. 11 is a circuit diagram of an NRZL/NRZI converting circuit incorporated in the 8-9 modulating circuit of FIG. 11;
FIG. 12 is a block diagram of an error correcting circuit to which the present invention is applied;
FIG. 13 is an illustration showing operation of the error correcting circuit shown in FIG. 13; and
FIG. 14 is a block diagram of another error correcting circuit to which the present invention is applied.

DETAILED DESCRIPTION OF THE INVENTION

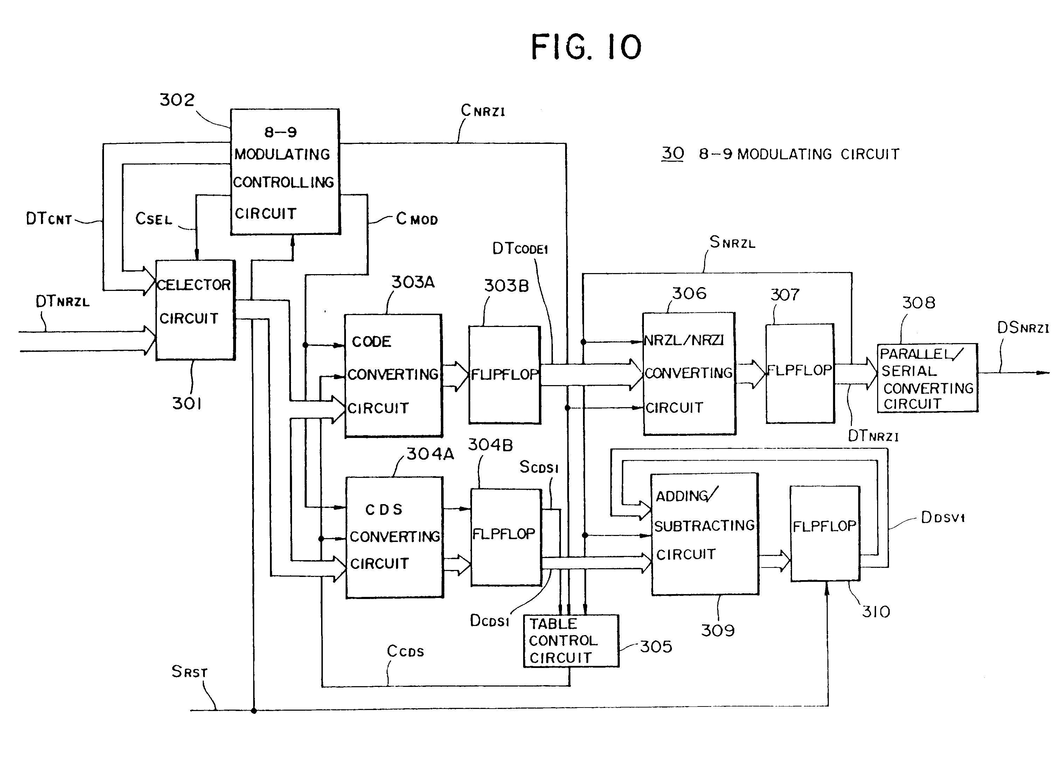

Referring first to FIG. 10, there is shown an 8-9 modulating circuit to which the present invention is applied. The 8-9 modulating circuit is generally denoted at 30 and is suitably incorporated in a magnetic recording and reproducing device not shown which may include such recording system 1 as shown in FIG. 3 and such reproducing system 20 as shown in FIG. 8. The 8-9 modulating circuit 30 includes a selector circuit 301 at which it receives input data $DT_{NRZL}$ in the form of an NRZL code of 8 bits.

Also, byte count data $DT_{CNT}$ sent out from an 8-9 modulation controlling circuit 302 are inputted to the selector circuit 301, and either input data $DT_{NRZL}$ or byte count data $DT_{CNT}$ are selectively inputted to a code converting circuit 303A and a CDS converting circuit 304A in response to an input selection control signal $C_{SEL}$ supplied from the 8-9 modulation controlling circuit 302.

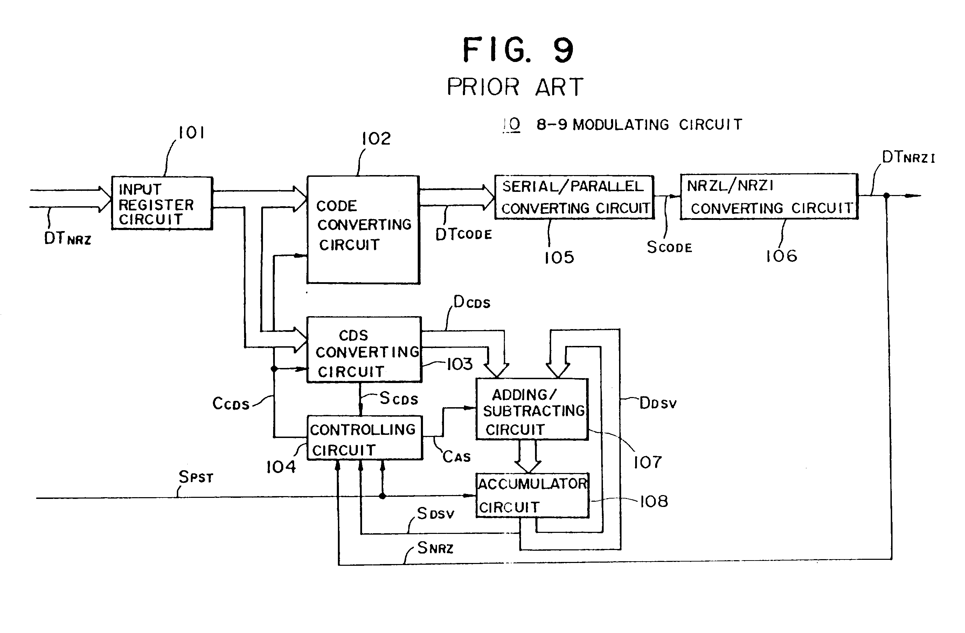

The code converting circuit 303A has a construction of a ROM, and contents of a code conversion table (Table 3 Randomized 8-bit Byte to 9-bit NRZL Word Mapping (pages 15 to 20)) specified in the ID-1 format are stored in the ROM of the code converting circuit 303A similarly, to the conventional code converting circuit 102 shown FIG. 9. Further, pattern data $DT_{PTN}$ corresponding to the rising sequence RUS of the preamble portion PR, the synchronization codes $SYNC_{PR}$ and $SYNC_{PS}$ of the preamble portion PR and postamble portion PS and the block synchronization codes $SYNC_{BLK}$ of the synchronization blocks BLK are stored in an area of the ROM of the code converting circuit 303A following the code conversion table.

Here, in the case of the present 8-9 modulating circuit 30, the pattern data $DT_{PTN}$ are constituted from first pattern data $DT_{PTN1}$ of 2 bytes of patterns of "001110001" and "110001110" in order from the LSB as the rising sequence RUS of the preamble portion PR, second pattern data $DT_{PTN2}$ of 4 bytes of "000011001", "111111110", "010111000" and "000001101" in order from the LSB as the synchronization codes $SYNC_{PR}$ and $SYNC_{PS}$ of the preamble portion PR and postamble portion PS, and third pattern data $DT_{PTN3}$ of 4 bytes of "111100110", "000000001", "101000111" and "111110010" in order from the LSB as the block synchronization code $SYNC_{BLK}$ of the synchronization block BLK.

It is to be noted that the code converting operation of the code converting circuit 303A is controlled in accordance with a mode control signal $C_{MOD}$ sent out from the 8-9 modulation controlling circuit 302, and when the mode control signal $C_{MOD}$ represents a conversion mode for the rising sequence RUS of the preamble portion PR, byte count data $DT_{CNT}$ which include 10 repeats of count values "0" and "1" are inputted to the code converting circuit 303A from the 8-9 modulation controlling circuit 302 by way of the selector 301.

Consequently, the code converting circuit 303A reads out the patterns "001110001" and "110001110" of the first pattern data $DT_{PTN1}$ alternately, and thus, as the rising sequence RUS of the preamble portion PR, a magnetization pattern of 180 bits consisting of 10 repeats of a symbol of 18 bits of "001110001 110001110" in order from the LSB is sent out as code word data $DT_{CODE1}$ to an NRZL/NRZI converting circuit 306 by way of a first flipflop 303B.

On the other hand, when the mode control signal $C_{MOD}$ represents another conversion mode for the synchronization code $SYNC_{PR}$ or $SYNC_{PS}$ of the preamble portion PR or postamble portion PS, byte count data $DT_{CNT}$ having a count value of "0", "1", "2" or "3" are inputted to the code converting circuit 303A from the 8-9 modulation controlling circuit 302 by way of the selector 301.

Consequently, the code converting circuit 303A successively reads out the patterns "000011001", "111111110", "010111000" and "000001101" of the second pattern data $DT_{PTN2}$, and thus, as the synchronization code $SYNC_{PR}$ or $SYNC_{PS}$ of the preamble portion PR or postamble portion PS, a magnetization pattern of 36 bits of "000011001 111111110 010111000 000001101" in order from the LSB is sent out as code word data $DT_{CODE1}$ to the NRZL/NRZI converting circuit 306 by way of the first flipflop 303B.

Otherwise, when the mode control signal $C_{MOD}$ represents a conversion mode for the block synchronization code $SYNC_{BLK}$ of the synchronization block BLK, byte count data $DT_{CNT}$ having a count value "0", "1", "2" or "3" are inputted to the code converting circuit 303A from the 8-9 modulation controlling circuit 302 by way of the selector 301.

Consequently, the code converting circuit 303A successively reads out the patterns "111100110", "000000001", "101000111" and "111110010" of the third pattern data $DT_{PTN3}$, and thus, as the block synchronization code $SYNC_{BLK}$ of the synchronization block BLK, a magnetization pattern of 36 bits of "111100110 000000001 101000111 111110010" in order from the LSB is sent out as code word data $DT_{CODE1}$ to the NRZL/NRZI converting circuit 306 by way of the first flipflop 303B.

It is to be noted that, in case the mode control signal $C_{MOD}$ represents any other mode than those described above, input data $DT_{NRZL}$ in the form of an NRZL code of 8 bits are inputted to the code converting circuit 303A by way of the selector 301, and code word data $DT_{CODE1}$ obtained by conversion of the input data $DT_{NRZL}$ into an NRZL code of 9 bits are sent out from a memory address corresponding to the input data $DT_{NRZL}$ and a CDS selection signal $C_{CDS}$ inputted from a table control circuit 305 to the NRZL/NRZI converting circuit 306 by way of the first flipflop 303B similarly as in the case of the conventional code converting circuit 102 shown in FIG. 9.

Here, the NRZL/NRZI converting circuit 306 has a construction of a ROM, and contents of a memory address corresponding to code word data $DT_{CODE1}$ in the form of an NRZL code of parallel 9 bits and an initial value signal $S_{NRZL}$ are read out from the ROM of the NRZL/NRZI converting circuit 306. Then, output data $DT_{NRZI}$ of an NRZI code of parallel 9 bits obtained by such reading are sent out to a parallel/serial converting circuit 308 by way of a second flipflop 307.

It is to be noted that the initial value signal $S_{NRZL}$ is formed from the MSB of output data $DT_{NRZI}$ sent out from the second flipflop 307 and is used as an initial value when code word data $DT_{CODE1}$ in the form of an NRZL code of a succeeding next one byte are to be NRZI converted.

In the case of the present 8-9 modulating circuit 30, an NRZI conversion control signal $C_{NRZI}$ is inputted from the 8-9 conversion controlling circuit 302 to the NRZL/NRZI converting circuit 306, and when the NRZI conversion control signal $C_{NRZI}$ represents non-conversion, that is, when code word data $DT_{CODE1}$ inputted are predetermined pattern data $DT_{PTN1}$, $DT_{PTN2}$ or $DT_{PTN3}$ in the form of the rising sequence RUS of the preamble portion PR, the synchronization code SYNCPR or SYNC$_{PS}$ of the preamble portion PR or postamble portion PS or the block synchronization code $SYNC_{BLK}$ of the synchronization block BLK, the code word data $DT_{CODE1}$ inputted thereto are sent out as they are to the parallel/serial converting circuit 308 by way of the second flipflop 307.

Thus, an NRZI signal $DT_{NRZI}$ obtained by 8-9 modulation and NRZL/NRZI conversion of input data $DT_{NRZL}$ and formatted in accordance with the ID-1 format is sent out from the parallel/serial converting circuit 308.

Meanwhile, the CDS converting circuit 304A has a construction of a ROM similar to that of the code converting circuit 303A, and contents of a CDS conversion table (Table 3 Randomized 8-bit Byte to 9-bit NRZL Word Mapping (pages 15 to 20)) specified in the ID-1 format are stored in the ROM of the CDS converting circuit 304A similarly as in the case of the conventional CDS converting circuit 103 shown in FIG. 9. In addition, in the case of the present 8-9 modulating circuit 30, CDS data $D_{CDS1}$ corresponding to pattern data $DT_{PTN}$ stored in the code converting circuit 303A are stored in an area of the ROM of the CDS converting circuit 304A following the CDS conversion table.

It is to be noted that also the CDS converting operation of the CDS converting circuit 304A is controlled in response to a mode control Signal $C_{MOD}$ sent out from the 8-9 modulation controlling circuit 302 similarly to the code converting circuit 303A described hereinabove, and when the mode control signal $C_{MOD}$ represents a conversion mode for the rising sequence RUS of the preamble portion PR, another conversion mode for the synchronization code $SYNC_{PR}$ or $SYNC_{PS}$ of the preamble portion PR or postamble portion PS or a further conversion mode for the block synchronization code $SYNC_{BLK}$ of the synchronization block BLK. CDS data $D_{CDS1}$ are read out from a memory address represented by contents of the mode control signal $C_{MOD}$ and byte count data $DT_{CNT}$. The CDS data $D_{CDS1}$ thus read out are sent out to an adding/subtracting circuit 309 by way of a third flipflop 304B.

The adding/subtracting circuit 309 adds or subtracts CDS data $D_{CDS1}$ to or from DSV data $D_{DSV1}$ in response to an initial value signal $S_{NRZL}$ inputted from the second flipflop 307, and a result of such calculation is added cumulatively at a fourth flipflop 310. DSV data $D_{DSV1}$ obtained by such addition are inputted to the adding/subtracting circuit 309.

Meanwhile, a CDS signal $S_{CDS1}$ which is sent out from the CDS converting circuit 304A by way of the third flipflop 304B, an NRZI conversion control signal $C_{NRZI}$ sent out from the 8-9 modulation controlling circuit 302 and an initial value signal $S_{NRZL}$ sent out from the second flipflop 307 are all inputted to the table control circuit 305. Then, the table control circuit 305 sends out a CDS selection signal $C_{CDS}$ for the code converting circuit 303A and CDS converting circuit 304A in accordance with a method specified by control tables (Table 4 9-bit NRZL Word Selection (page 101), Table 5 DSV Calculation Using Preamble Run-up and Sync Pattern (page 102)) of the ID-1 format.

It is to be noted that, in the 8-9 modulating circuit 30, a reset signal $S_{RST}$ is inputted at a timing of the top of one sector SEC to the 8-9 modulation controlling circuit 302 and fourth flipflop 310, and consequently, the entire 8-9 modulating circuit 30 is initialized for each one sector SEC.

Meanwhile, in the control tables (Table 4 9-bit NRZL Word Selection (page 101), Table 5 DSV Calculation Using Preamble Run-up and Sync Pattern (page 102)) of the ID-1 format, it is determined whether a positive CDS or a negative CDS is to be selected depending upon whether the value of DSV is in the positive or equal to or smaller than 0, but in the case of the present 8-9 modulating circuit 30, CDS and DSV are used all in the opposite polarities so that it may be determined which one of them is to be selected depending upon whether the value of DSV is equal to or greater than 0 or in the negative. Consequently, the MSB of DSV can be used as data representative of a state of the DSV.

According to the construction described so far, since code word data $DT_{CODE1}$ in the form of an NRZI code corresponding to a specified magnetization pattern $DT_{PTN1}$, $DT_{PTN2}$ or $DT_{PTN3}$ are passed and the last bit of the code word data $DT_{CODE1}$ is used as an initial value $S_{NRZL}$ when subsequent code word data $DT_{CODE1}$ in the form of an NRZL code are to be NRZL/NRZI converted, an initial value for the NRZL/NRZI conversion can be set with a simple construction. Further, since inputted information data $DT_{NRZL}$ ($DT_{CODE1}$) are NRZL/NRZI converted in the state of parallel data, adjustment of a timing in NRZL/NRZI conversion can be simplified.

In doing this, a magnetic recording device which can perform NRZL/NRZI conversion wherein a magnetization pattern includes data specified in advance can be realized with a simple construction.

It is to be noted that, while in the 8-9 modulating circuit described hereinabove the NRZL/NRZI converting circuit is described constituted from a ROM, it may otherwise be constructed, instead of such ROM, from a logic circuit consisting of a combination of a plurality of exclusive OR circuits.

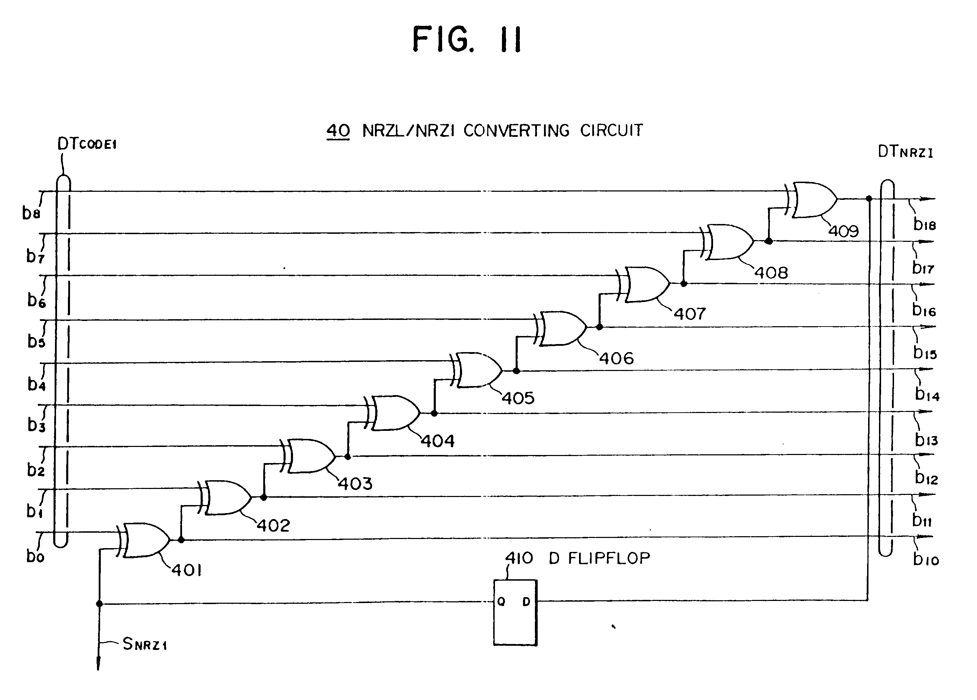

Incidentally, in the case of an NRZL/NRZI converting circuit 40 shown in FIG. 11, it is constructed from a combination of 9 exclusive OR circuits 401 to 409, and the most significant bit $b_{18}$ of output data $DT_{NRZI}$ of 9 bits NRZI converted immediately before then is delayed by one clock interval by a flipflop 410 and inputted to the first exclusive OR circuit 401.

Meanwhile, 9 bits beginning with the least significant bit be of 9-bit input data $DT_{NRZL}$, that is. bits $b_0$ to $b_8$, are inputted respectively to the first to ninth exclusive OR circuits 401 to 409, and logic outputs of the individual exclusive OR circuits 401 to 409 are sent out as 9 bits $b_{10}$ to $b_{18}$ of output data $DT_{NRZI}$ and inputted to the second to ninth exclusive OR circuits 402 to 409 to which the individual bits $b_1$ to $b_8$ individually added by one bit from the least significant bit are inputted.

In this manner, in the case of the present NRZL/NRZI converting circuit 40. NRZL/NRZI conversion is performed using the most significant bit $b_{18}$ of 9-bit output data $DT_{NRZI}$ NRZI converted immediately before then as an initial value.

It is to be noted that, in order for the present NRZL/NRZI converting circuit 40 to send out 9-bit input data $DT_{NRZL}$ as they are as output data $DT_{NRZI}$, logic outputs to be inputted from the first to eighth exclusive OR circuits 401 to 408 to the second to ninth exclusive OR circuits 402 to 409 and the most significant bit $b_{18}$ of immediately preceding 9-bit output data $DT_{NRZI}$ to be inputted to the first exclusive OR circuit 401 should be controlled to be a value "0" level.

Further, while the 8-9 modulating circuit described hereinabove is described incorporated in a magnetic recording device based on the ID-1 format, it can be suitably applied widely to information transmission devices wherein information data in the form of an NRZL code to be transmitted are converted into an NRZI code.

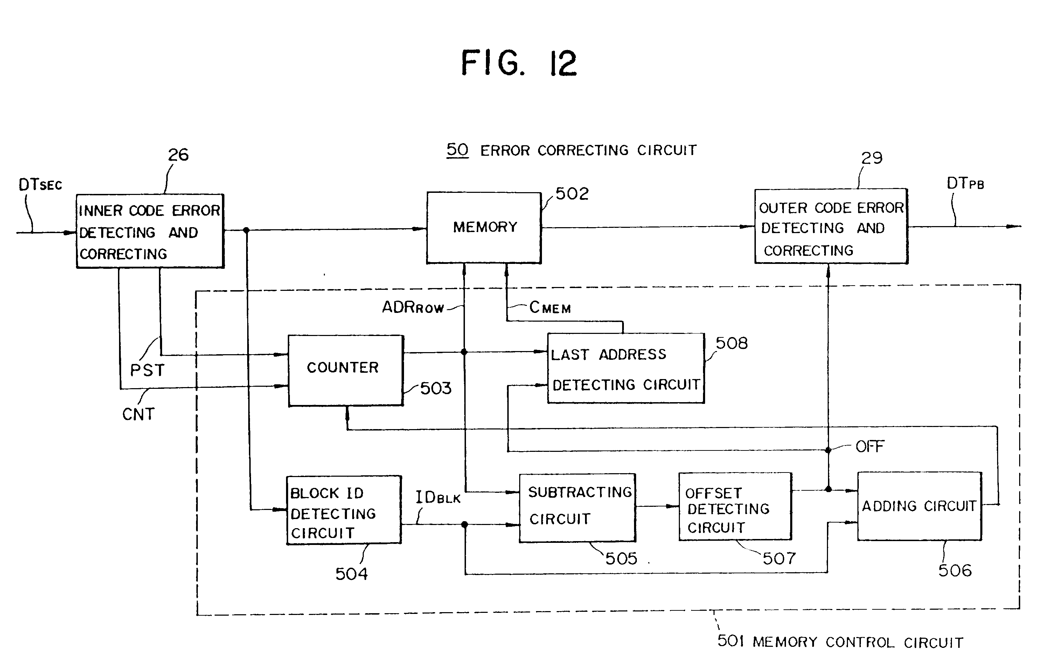

Referring now to FIG. 12, there is shown an error correcting circuit to which the present invention is applied. The error correcting circuit shown is generally denoted at 50 and includes, similarly as in the case of the reproducing system 20 of the magnetic recording and reproducing device shown in FIG. 8, an inner code error detecting and correcting circuit 26 which successively executes error detection and correction using an inner code for each of synchronization blocks $BLK_0$ to $BLK_{255}$ of demodulated reproduction data $DT_{SEC}$ for one sector SEC and writes identification data $ID_B$, synchronization block data $DT_{BLK}$, a parity code RI and an inner code error flag $FLG_{IN}$ of the length, for example, of one byte all obtained by such error detection and correction into a memory 502 in the form of a RAM (random access memory) having a similar construction to that of the conventional memory 28 described hereinabove in response to address information received from a memory control circuit 501.

Meanwhile, an outer code error detecting and correcting circuit 29 is constructed such that it successively reads the memory 502 for each 128 bytes in the direction of columns in response to address information received from the memory control circuit 501 and then executes error detecting and correcting processing using an outer code with reference to an inner code error flag $FLG_{IN}$ so that information data $DT_{USE}$ recorded on a magnetic tape 15 may be reproduced.

Practically, the memory control circuit 501 includes an 8-bit counter 503 which is reset to a value "0" in response to a reset signal RST which is sent out at a timing at which sector identification data $ID_{SEC1}$ are detected by the inner code error detecting and correcting circuit 26.

The counter 503 is of the cyclic type which executes a counting up operation successively from a count value "0" to another count value "255" in response to a count pulse CNT which is developed from the inner code error detecting and correcting circuit 26 each time a synchronization block $BLK_0$ to $BLK_{255}$ is inputted but which returns to the value "0" when an overflow takes place.

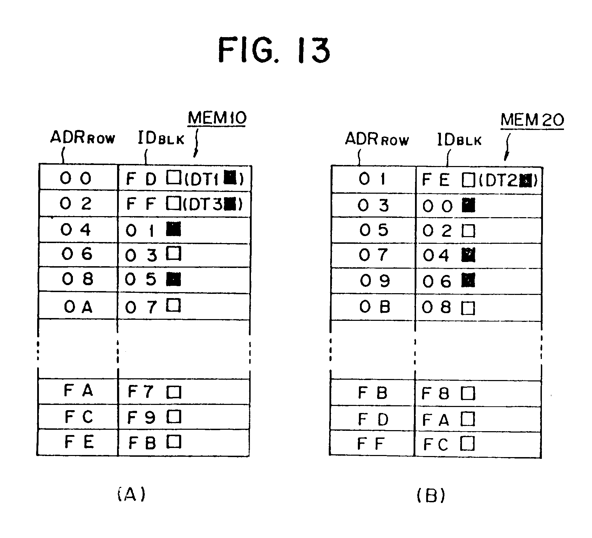

Meanwhile, the memory 502 includes a pair of memory matrices MEM10 and MEM20 (refer to FIG. 13) each having a capacity of 154 x 128 bytes in rows and columns similarly to the memories MEM1 and MEM2 described hereinabove with reference to FIG. 5 so that identification data $ID_B$ and synchronization block data $DT_{BLK}$ of one synchronization block BLK inputted from the inner code error detecting and correcting circuit 26 may be stored therein by each 154 bytes in a row.

It is to be noted that a count value sent out from the counter 503 is used as a memory address $ADR_{ROW}$ of a row of the memory matrices MEM10 and MEM20 and is supplied to the memory 502.

Here, writing of identification data $ID_B$ and synchronization block data $DT_{BLK}$ for one synchronization block BLK into the memory 502 proceeds such that such data for even-numbered ones of the memory addresses $ADR_{ROW}$ are successively written into the first memory matrix MEM10 while the remaining data for odd-numbered ones of the memory addresses $ADR_{ROW}$ are successively written into the second memory matrix MEM20.

In addition, in the case of the memory control circuit 501 of the present embodiment, identification data $ID_B$ and synchronization block data $DT_{BLK}$ for one synchronization block BLK sent out from the inner code error detecting and correcting circuit 26 are successively inputted to a block ID detecting circuit 504.

The block ID detecting circuit 504 detects identification data $ID_B$ of a synchronization block BLK which is free from an error or an error of which has been corrected while referring to an inner code error flag $FLG_{IN}$ in the synchronization block BLK, and sends out the thus detected identification data $ID_B$ to a subtracting circuit 505 and an adding circuit 506.

Practically, the identification data $ID_B$ are incremented, when successive synchronization blocks BLK are free from an error or have been corrected to eliminate an error, for each of such synchronization blocks BLK similarly to the memory address $ADR_{ROW}$ sent out from the counter 503.

Meanwhile, the subtracting circuit 505 calculates a difference between identification data $ID_B$ received from the block ID detecting circuit 304 and a memory address $ADR_{ROW}$ received from the counter 503, and sends out a result of such calculation as a memory offset OFF to an offset detecting circuit 507 having a construction of a register.

Practically, in the memory control circuit 501, the counter 503 is incremented in response to a count pulse CNT until a first one of synchonization blocks BLK for one sector SEC which is free from an error or has been corrected to eliminate an error is inputted to the memory control circuit 501, and identification data $ID_B$ and synchronization block data $DT_{BLK}$ for one synchronization block BLK are written into a location of the memory address $ADR_{ROW}$ designated by the count value of the counter 503.

On the other hand, if a synchronization block BLK of synchronization blocks BLK for one sector SEC which is free from an error or has been corrected to eliminate an error is first inputted, then a difference between the identification data $ID_B$ and the memory address $ADR_{ROW}$, is stored as a memory offset OFF into the offset detecting circuit 507.

Also in case a synchronization block BLK for which error correction is impossible is inputted after then, identification data $ID_B$ and synchronization block data $DT_{BLK}$ for one synchronization block BLK are written into a location of the memory designated by the memory address $ADR_{ROW}$ received from the counter 503.

On the other hand, if a synchronization block BLK which is free from an error or has been corrected to eliminate an error is inputted, then the identification data $ID_B$ of the synchronization block BLK and a memory offset OFF held in the offset detecting circuit 507 are added by the adding circuit 506, and a result of the addition is loaded into the counter 503. Then, the identification data $ID_B$ and synchronization block data $DT_{BLK}$ for one synchronization block BLK are written into a location of the memory designated by a memory address $ADR_{ROW}$ which is sent out from the counter 503 after such loading.

It is to be noted that a memory offset OFF held in the offset detecting circuit 507 and a memory address $ADR_{ROW}$ sent out from the counter 503 are inputted to a last address detecting circuit 508.

The last address detecting circuit 508 sends out, when it detects, using a memory offset OFF, a synchronization block BLK at which the memory address $ADR_{ROW}$ for one sector SEC is equal to a sum of the memory offset OFF and the value "255", a memory control signal $C_{MEM}$ to control the memory 502 to a writing disabled condition so that writing of succeeding synchronization blocks BLK may be inhibited.

The outer code error detecting and correcting circuit 29 sets, as a reading start address, a first byte of synchronization block data $DT_{BLK}$ corresponding to an offset OFF received from the offset detecting circuit 507, and then successively counts up the reading address in the direction of rows alternately from the start address. The outer code error detecting and correcting circuit 29 then reads out data of 128 bytes from the memory addresses obtained by such successive counting up operation as an outer data block $DO_{\emptyset}$ and executes outer code error detecting and correcting processing of the outer data block $DO_{\emptyset}$.

After then, the outer code error detecting and correcting circuit 29 repeats similar processing to that described above by 152 times and sets, as a reading start address, a first byte of the synchronization block data $DT_{BLK}$ corresponding to an address obtained by addition of the value "1" to the memory offset OFF, and then reading processing of an outer data block DO of 128 bytes is executed by 153 times in a similar manner as described above.

The synchronization block data $DT_{BLK}$ written in the memory 502 are read out in this manner, and the outer code error detecting and correcting circuit 29 executes outer code error detecting and correcting processing including an erasure calculation with reference to the inner code error flag $FLG_{IN}$ and executes re-arrangement in accordance with a series of outer codes. Information data $DT_{USE}$ recorded on the magnetic tape 15 can be reproduced to send out reproduction data $DT_{PB}$ in this manner.

In the construction described so far, if, for example, identification data $ID_B$, synchronization block data $DT_{BLK}$, a parity code RI and an inner code error flag $FLG_{IN}$ for one synchronization block BLK sent out from the inner code error detecting and correcting circuit 26 are employed as synchronization block input data DT and synchronization block input data DT following the top of one sector SEC are successively numbered, then the memory control circuit 501 executes writing processing into the memory 502 in such an order as seen in FIG. 13 in which identification data $ID_B$ corresponding to the memory address $ADR_{ROW}$ and synchronization block input data DT are represented in hexadecimal notation.

In particular, the counter 503 of the memory control circuit 501 is reset at the top of one sector SEC in response to a reset signal RST sent out from the inner code error detecting and correcting circuit 26 and writes synchronization block input data DT received beginning with the top of one sector SEC successively into the memory 502 beginning with the start address.

It is to be noted that the memory 502 includes the two memories MEM10 and MEM20 and, when the memory address $ADR_{ROW}$ sent out from the counter 503 has an even-numbered value, data are written into the first memory MEM10, but when the memory address $ADR_{ROW}$ has an odd-numbered value, data are written into the second memory MEM20.

Accordingly, synchronization block input data DT1 which are inputted first are written into an address of the first memory MEM10 designated by the memory address $ADR_{ROW}$ of the value "00", and then next synchronization block input data DT2 are written into an address of the second memory MEM20 designated by the memory address $ADR_{ROW}$ of the value "01", whereafter the synchronization block input data DT3 are written into an address of the first memory MEM10 designated by the memory address $ADR_{ROW}$ of the value "02".

It is to be noted that, in FIG. 13, the first to third synchronization block input data DT1 to DT3 cannot be corrected to eliminate an error and are each indicated by a mark "■".

Meanwhile, since the succeeding fourth and fifth synchronization block input data DT4 and DT5 cannot be corrected to eliminate an error, they are individually into addresses having address values of "03" and "04" designated by the memory address $ADR_{ROW}$ sent out from the counter 503.

As for the sixth synchronization block input data DT6 inputted subsequently, it is detected by the block ID detecting circuit 504 that identification data $ID_B$ have a value equal to "02". Thus, it is determined that the sixth synchronization block input data DT6 are free from an error or can be corrected to eliminate an error and such synchronization block input data are indicated by another mark "□" in FIG. 13.

In this instance, since the data of "02" are synchronization input data DT which are first detected to be free from an error or be capable of being corrected to eliminate an error in one sector SEC by the block ID detecting circuit 504, the subtracting circuit 505 subtracts the value "02" of the identification data $ID_B$ from the value "05" of the memory address $ADR_{ROW}$ then and determines a value "03" obtained by such subtraction as a memory offset OFF. The subtracting circuit 505 thus sends out the memory offset OFF to the offset detecting circuit 507 and writes the inputted sixth synchronization block input data DT6 into an address of the value "05" designated by the memory address $ADR_{ROW}$.

The seventh synchronization block input data DT7 inputted after then are synchronization block input data DT which are free from an error or can be corrected to eliminate an error as can be seen from the mark "□" in FIG. 13. In this instance, the value "03" of identification data $ID_B$ sent out from the block ID detecting circuit 504 and the value "03" of the memory offset OFF held in the offset detecting circuit 507 are added by the adding circuit 506, and a result of such addition is loaded into the counter 503 while the inputted seventh synchronization input data DT7 are written into an address designated by the memory address $ADR_{ROW}$ having the value "06" equal to the result of the addition.

Three synchronization block input data DT which are inputted successively after then have identification data $ID_B$ having the values "04", "05" and "06" but are synchronization block input data DT which, as can be seen from the mark "■" in FiG. 13, cannot be corrected to an eliminate an error due to a cause other than the identification data $ID_B$.

Accordingly, the counter 503 successively counts up from the value "06" loaded from the adding circuit 506, and the inputted three synchronization block input data DT are successively written into addresses of the values "07", "08" and "09" of the memory address $ADR_{ROW}$ obtained by such counting up operation.

Such processing as described above is repeated to write inputted synchronization block input data DT successively into an address of the memory corresponding to a value of the memory address $ADR_{ROW}$. Then, when synchronization block input data DT wherein the identification data $ID_B$ has the value "FD" are inputted, the memory address $ADR_{ROW}$ sent out from the counter 503 by way of the adding circuit 506 now exhibits the value "00" obtained by addition of the value "03" of the memory offset OFF to the value "FD" of the identification data $ID_B$. The memory address $ADR_{ROW}$ thus completes its cycle of operation.

In this instance, the synchronization block input data DT1 are written in the address of the memory address designated by the value "00" of the memory address $ADR_{ROW}$. However, the first synchronization block input data DT necessary for the outer code error detecting and correcting circuit 29 are written in the address of the value "03" of the memory address $ADR_{ROW}$ as represented by the value "03" of the memory offset OFF, and accordingly, it is determined that synchronization block input data DT in any address preceding to the address of the value "03" need not be transmitted to the outer code circuit.

Accordingly, synchronization block input data DT wherein the identification data $ID_B$ have the value "FD" are overwritten in the address of the value "00" of the memory address $ADR_{ROW}$, and then synchronization block input data which are inputted successively after then and wherein the identification data $ID_B$ have the values "FE" and "FF" are also overwritten into the addresses of the values "01" and "02" of the memory address $ADR_{ROW}$, respectively.

It is to be noted that the last address detecting circuit 508 detects then that the memory address $ADR_{ROW}$ outputted from the counter 503 is equal to the value "02" obtained by addition of the value "03" of the memory offset OFF to the value "FF", and sends out a memory control signal $C_{MEM}$ to control the memory 502 into a write disabled condition so that writing of succeeding synchronization block input data DT into the memory 502 may be inhibited.

Since the error correcting circuit 50 is constituted such that not only synchronization block input data which are free from an error or can be corrected to eliminate an error but also synchronization block input data which cannot be corrected to eliminate an error are written into the memory 502 in response to the memory address $ADR_{ROW}$ sent out from the counter 503 in this manner, even if error correction is impossible by a cause of an error which takes place at a portion other than synchronization block data $DT_{BLK}$, correct synchronization block data $DT_{BLK}$ can be transmitted to the outer code error detecting and correcting circuit 29.

Meanwhile, when the outer code error detecting and correcting circuit 29 reads the memory 502 in which synchronization block input data DT for one sector SEC are written in such a manner as described above, 128 bytes in the direction of columns as represented by the values "05", "07", ..., "FD", "FF", ..., "01" of the memory address $ADR_{ROW}$ starting from synchronization block data $DT_{BLK}$ written in an address of the second memory MEM20 designated by the memory address $ADR_{ROW}$ of the value "03" of the memory offset OFF received from the offset detecting circuit 507 are read out as a series of outer codes, and then 153 bytes starting from the top of synchronization block data $DT_{BLK}$ written in the memory address $ADR_{ROW}$ of the value "03" are read out successively by 153 times in a similar manner, whereafter 128 bytes in the direction of columns are successively read out from the first memory MEM10 in a similar manner beginning with an address of the value "04" obtained by addition of the value "01" to the value "03" of the memory offset OFF.

According to the construction described above, synchonization block input data DT sent out from the inner code error detecting and correcting circuit 26 are written, whether or not they have an error, into the memory 502 in response to a memory address $ADR_{ROW}$ sent out from the counter 503, and synchronization block input data DT at the top of one sector SEC are detected and held as a memory offset OFF in accordance with identification data $ID_B$ of synchronization block input data DT which are free from an error or can be corrected to eliminate an error while the memory 502 is read out in an order of a series of outer codes in response to the memory offset OFF by the outer code error detecting and correcting circuit 29. Consequently, correct synchronization block data $DT_{BLK}$ not only of synchronization block input data DT which are free from an error or can be corrected to eliminate an error but also of synchronization block input data DT for which error correction is impossible due to a cause of an error which takes place at a portion, for example, other than synchronization block data $DT_{BLK}$ can be sent to the outer code error detecting and correcting circuit 29. Accordingly, the error correcting circuit 50 can be realized which are significantly improved in accuracy in error detection and also in error correcting function as a whole.

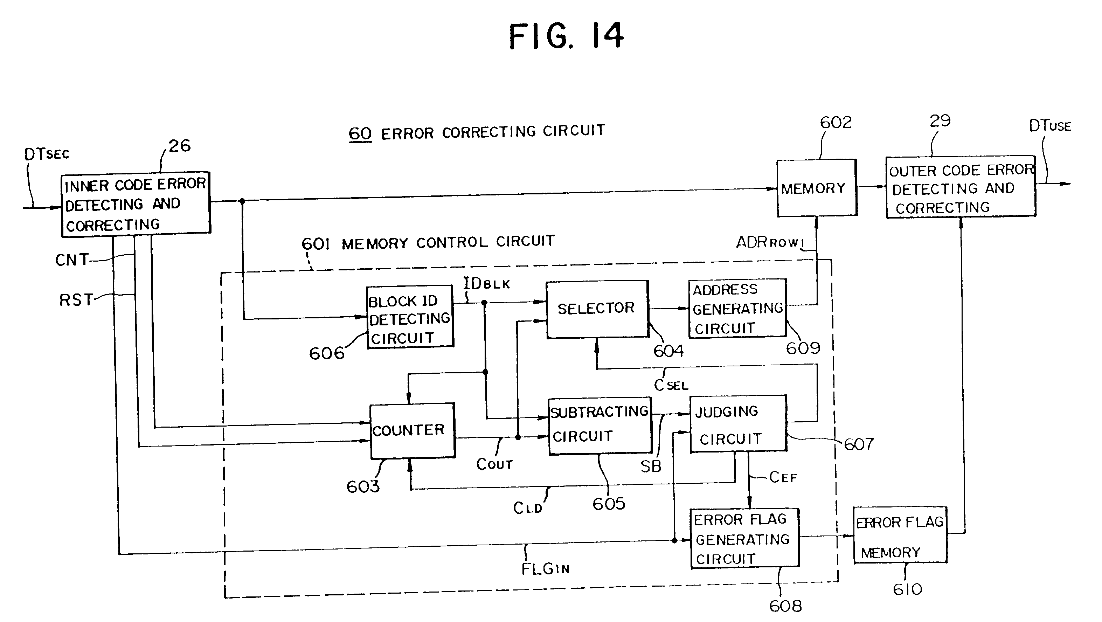

Referring now to FIG. 14, there is shown another error correcting circuit to which the present invention is applied. The error correcting circuit shown is generally denoted at 60 and includes, similarly as in the case of the reproducing system 20 of the magnetic recording and reproducing device shown in FIG. 8, an inner code error detecting and correcting circuit 26 which successively executes error detection and correction using an inner code for each of synchronization blocks $BLK_0$ to $BLK_{255}$ of demodulated reproduction data $DT_{SEC}$ for one sector SEC and writes identification data $ID_B$, synchronization block data $DT_{BLK}$ and a parity code RO all obtained by such error detection and correction into a memory 602 in the form of a RAM (random access memory) having a similar construction to that of the conventional memory 28 described hereinabove in response to address information received from a memory control circuit 601.

Meanwhile, an outer code error detecting and correcting circuit 29 is constructed such that it successively reads the memory 602 for each 128 bytes in the direction of columns and then executes error detecting and correcting processing using an outer code with reference to an inner code error flag $FLG_{IN}$ so that information data $DT_{USE}$ recorded on a magnetic tape 15 may be reproduced.

Practically, the memory control circuit 601 includes an 8-bit counter 603 which is reset to a value "0" in response to a reset signal RST which is sent out at a timing at which sector identification data $ID_{SEC1}$ are detected by the inner code error detecting and correcting circuit 26.

The counter 603 is of the cyclic type which executes a counting up operation successively from a count value "0" to another count value "255" in response to a count pulse CNT which is sent out from the inner code error detecting and correcting circuit 26 each time a synchronization block $BLK_0$ to $BLK_{255}$ is inputted but which returns to the value "0" when an overflow takes place. A count output $C_{OUT}$ of the counter 603 is sent out to a selector 604 and a subtracting circuit 605.

Further, in the case of the memory control circuit 601 of the present embodiment, data for one synchronization block BLK sent out from the inner code error detecting and correcting circuit 26 are successively inputted to a block ID detecting circuit 606.

The block ID detecting circuit 606 detects identification data $ID_B$ of a synchronization block BLK which is free from an error or an error of which has been corrected while referring to the inner code error flag $FLG_{IN}$ in the synchronization block BLK, and sends out the thus detected identification data $ID_B$ to the selector 604 and subtracting circuit 605.

Practically, the identification data $ID_B$ are incremented, when successive synchronization blocks BLK are free from an error or have been corrected to eliminate an error, for each of such synchronization blocks BLK similarly to the count output $C_{OUT}$ sent out from the counter 603.

Meanwhile, the memory 602 includes a pair of memories MEM10 and MEM20 (refer to FIG. 13) each having a capacity of 154 x 128 bytes in rows and columns similarly to the memories MEM1 and MEM2 described hereinabove with reference to FIG. 5 so that identification data $ID_B$, synchronization block data $DT_{BLK}$ and parity codes RO of one synchronization block BLK inputted from the inner code error detecting and correcting circuit 26 may be stored therein by each 154 bytes in a row.

The subtracting circuit 605 subtracts the count output $C_{OUT}$ from identification data $ID_B$ inputted thereto and supplies a difference value SB between them to a succeeding judging circuit 607.

It is to be noted that an inner code error flag $FLG_{IN}$ sent out from the inner code error detecting and correcting circuit 26 is inputted to the judging circuit 607 as well as to an error flag generating circuit 608.

Thus, if the judging circuit 607 checks the inner code error flag $FLG_{IN}$ and detects that a synchronization block BLK is free from an error or has been corrected to eliminate an error, then it judges, using a negative value N and a positive value M set in advance therein, whether or not the difference value SB satisfies the following expression:

$$N \leq SB \leq M \qquad (1)$$

If the expression (1) above is satisfied, then the judging circuit 607 sends out a selector control signal $C_{SEL}$ to the selector 44 to select identification data $ID_B$.

Consequently, identification data $ID_B$ are sent out to an address generating circuit 609 by way of the selector 604, and the identification data $ID_B$, synchronization block data $DT_{BLK}$ and a parity code RO for one synchronization block BLK are written into an address in the direction of rows corresponding to a memory address $ADR_{ROW1}$ generated by the address generating circuit 609 in response to the identification data $ID_B$.

It is to be noted that the judging circuit 607 sends out a counter control signal $C_{LD}$ to load a value of the identification data $ID_B$ then into the counter 603 so that a counting operation of the counter 603 may be executed from the value of the identification data $ID_B$ after then.

In addition, the judging circuit 607 sends out an error flag control signal $C_{EF}$ to the error flag generating circuit 608 to pass an inputted inner code error flag $FLG_{IN}$ therethrough. Consequently, the inner code error flag $FLG_{IN}$ is written as it is into an error flag memory 610.

On the other hand, when it is judged that the expression (1) is not satisfied, the judging circuit 607 sends out a selector control signal $C_{SEL}$ to the selector 604 to select the count output $C_{OUT}$.

Consequently, the count output $C_{OUT}$ is sent out to the address generating circuit 609 by way of the selector 604, and identification data $ID_B$, synchronization block data $DT_{BLK}$ and a parity code RO for one synchronization block BLK are written into an address of the memory in the direction of rows corresponding to a memory address $ADR_{ROW1}$ generated by the address generating circuit 609 in response to the count output $C_{OUT}$.

It is to be noted that the judging circuit 607 also sends out an error flag control signal $C_{EF}$ to the error flag generating circuit 608 to compulsorily set an inner code error flag $FLG_{IN}$. Consequently, also when no inner code error flag $FLG_{IN}$ is set, an error flag $FLG_{IN}$ is written into the error flag memory 610.

On the other hand, in case identification data $ID_B$, synchronization block data $DT_{BLK}$ and a parity code RO for one synchronization block BLK inputted from the inner code error detecting and correcting circuit 26 cannot be corrected to eliminate an error, the judging circuit 607 sends out a selector control signal $C_{SEL}$ to the selector 604 to select the count output $C_{OUT}$.

Consequently, the count output $C_{OUT}$ is sent out to the address generating circuit 609 by way of the selector 604, and identification data $ID_B$, synchronization block data $DT_{BLK}$ and a parity code RO for one synchronization block BLK are written into an address of the memory in the direction of rows corresponding to a memory address $ADR_{ROW1}$ generated by the address generating circuit 609 in response to the count output $C_{OUT}$.

It is to be noted that the judging circuit 607 sends out an error flag control signal $C_{EF}$ to the error flag generating circuit 608 to pass an inputted inner code error flag $FLG_{IN}$ therethrough. Consequently, the inner code error flag $FLG_{IN}$ is written as it is into the error flag memory 610.

Identification data $ID_B$ of successively inputted synchronization blocks BLK originally have a continuity, and in case synchronization blocks BLK which are free from an error or can be corrected to eliminate an error are inputted successively, the value of identification data $ID_B$ sent out from the block ID detecting circuit 606 is always equal to the value of the count output $C_{OUT}$ sent out from the counter 603.

Accordingly, the difference value SB sent out from the subtracting circuit 605 must normally have a value equal to "0". However, if the difference value SB is not equal to the value "0", then it is considered that identification data $ID_B$ of synchronization blocks BLK are made discontinuous by some cause.

Thus, in the case of the present embodiment, it is judged by the judging circuit 607 whether or not the expression (1) is satisfied in order to judge the correctness of the synchronization block BLK. Then, in case it is judged that the synchronization block BLK is correct, identification data $ID_B$ and synchronization block data $DT_{BLK}$ for the one synchronization block BLK are written into a memory address $ADR_{ROW1}$ determined from the identification data $ID_B$ of the synchronization block BLK.

On the contrary, in case it is judged that the synchronization block BLK is not correct, identification data $ID_B$ and synchronization block data $DT_{BLK}$ for the one synchronization block BLK are written into a memory address $ADR_{ROW1}$ determined from a count output $C_{OUT}$ sent out from the counter 603 from the reason that the count value $C_{OUT}$ is continuous from identification data $ID_B$ of a correct identification block BLK which has been inputted preceding to the incorrect synchronization block BLK.

Further, as it is judged that the synchronization block BLK is not correct, the inner code error detecting flag $FLG_{IN}$ for the synchronization block BLK is set as an error and written into the error flag memory 610.

In addition, in case the expressiong (1) is satisfied, that is, in case it is judged that the synchronization block BLK is correct, the judging circuit 607 loads a value of the identification data $ID_B$ then into the counter 603 so that the values of the count output $C_{OUT}$ and identification data $ID_B$ may coincide with each other.

On the contrary, in case it is not judged that the synchronization block BLK is correct, or in case the inner code error detecting flag $FLG_{IN}$ indicates that error correction is impossible, the count output $C_{OUT}$ of the counter 603 is incremented successively.

According to the construction described so far, the continuity of identification data $ID_B$ of synchronization blocks BLK inputted from the inner code error detecting and correcting circuit 26 is monitored, and it is judged whether or not the synchronization block BLK is a correct synchronization block BLK to control a write address of the memory 602 and the inner code error detecting flag $FLG_{IN}$. Consequently, the error detecting circuit 60 which can prevent, even if an error in detection takes place at the inner code error detecting and correcting circuit 26 due to some cause, correction in error by the outer code error detecting and correcting circuit 29 can be realized with a simple construction.

It is to be noted that, while the error correcting circuits 50 and 60 are described separately from each other in order to make operation clear, it is practical to use the error correcting circuits 50 and 60 in a suitable combination with each other.

Further, while in the embodiments described above a memory is provided which includes memory portions for individually storing halves of synchronization blocks for one sector therein in accordance with decentralized processing of a recording system, similar effects to those of the embodiments described above can be achieved even with a single memory for storing synchronization blocks for one sector therein.

On the other hand, while in the embodiments described above a memory address is obtained from a count output of an 8-bit cyclic counter, the construction of a counter for providing a memory address is not limited to such specific one and a counter of a different type may be used in accordance with construction of a memory.

In addition, while in the embodiments described above the present invention is applied to a magnetic recording device of the ID-1 format, the present invention is not limited to this and can be applied suitably to various information transmission systems wherein an error detection code of the product sign format is applied to information data.

In the drawings:

FIG. 1 - RECORD PATTERN

14    MAGNETIC TAPE

FIG. 2 - CONTENTS OF RECORD TRACKS

SEC    SECTOR
TR    RECORD TRACK

FIG. 3 - RECORDING SYSTEM OF DATA RECORDER

1    RECORDING SYSTEM
2    OUTER CODE GENERATING CIRCUIT
4    MEMORY
5    IDENTIFICATION DATA GENERATING CIRCUIT
6    INNER CODE GENERATING CIRCUIT
8    PREAMBLE PORTION AND POSTAMBLE PORTION GENERATING CIRCUIT
9    DATA RANDOMIZING CIRCUIT
10    8-9 MODULATING CIRCUIT
12    SYNCHRONIZATION CODE GENERATING CIRCUIT
13    PARALLEL/SERIAL CONVERTING CIRCUIT
14    RECORDING AND AMPLIFYING CIRCUIT
15    MAGNETIC TAPE
16    MAGNETIC HEAD

FIG. 5 - CONSTRUCTION OF MEMORY
FIG. 7 - DATA MAP
FIG. 8 - REPRODUCING SYSTEM CIRCUIT OF DATA RECORDER

15    MAGNETIC TAPE
16    MAGNETIC HEAD
20    REPRODUCING SYSTEM
21    REPRODUCING AND AMPLIFYING CIRCUIT
22    SERIAL/PARALLEL CONVERTING CIRCUIT
23    SYNCHRONIZATION CODE DETECTING CIRCUIT
24    8-9 DEMODULATING CIRCUIT
25    DATA DERANDOMIZING CIRCUIT
26    INNER CODE ERROR DETECTING AND CORRECTING CIRCUIT
27    IDENTIFICATION DATA DETECTING CIRCUIT
28    MEMORY
29    OUTER CODE ERROR DETECTING AND CORRECTING CIRCUIT

FIG. 9 - PRIOR ART 8-9 MODULATING CIRCUIT

10    8-9 MODULATING CIRCUIT
101    INPUT REGISTER CIRCUIT
102    CODE CONVERTING CIRCUIT
103    CDS CONVERTING CIRCUIT
104    CONTROLLING CIRCUIT
105    SERIAL/PARALLEL CONVERTING CIRCUIT
106    NRZL/NRZI CONVERTING CIRCUIT
107    ADDING/SUBTRACTING CIRCUIT
108    ACCUMULATOR CIRCUIT

FIG. 10 - 8-9 MODULATING CIRCUIT OF THE INVENTION

30    8-9 MODULATING CIRCUIT
301    SELECTOR CIRCUIT
302    8-9 MODULATION CONTROLLING CIRCUIT
303A    CODE CONVERTING CIRCUIT
303B    FLIPFLOP
304A    CDS CONTROLLING CIRCUIT
304B    FLIPFLOP
305    TABLE CONTROL CIRCUIT
306    NRZL/NRZI CONVERTING CIRCUIT
307    FLIPFLOP
308    PARALLEL/SERIAL CONVERTING CIRCUIT
309    ADDING/SUBTRACTING CIRCUIT
310    FLIPFLOP

FIG. 11 - NRZL/NRZI CONVERTING CIRCUIT OF ANOTHER EMBODIMENT

40    NRZL/NRZI CONVERTING CIRCUIT
410    D FLIPFLOP

FIG. 12 - ERROR CORRECTING CIRCUIT ACCORDING TO THE INVENTION

26    INNER CODE ERROR DETECTING AND CORRECTING CIRCUIT
29    OUTER CODE ERROR DETECTING AND CONVERTING CIRCUIT
50    ERROR CORRECTING CIRCUIT
501    MEMORY CONTROL CIRCUIT
502    MEMORY
503    COUNTER
504    BLOCK ID DETECTING CIRCUIT
505    SUBTRACTING CIRCUIT
506    ADDING CIRCUIT
507    OFFSET DETECTING CIRCUIT
508    LAST ADDRESS DETECTING CIRCUIT

FIG. 13 - WRITING OPERATION OF MEMORY
FIG. 14 - ERROR CORRECTING CIRCUIT ACCORDING TO THE INVENTION

26　INNER CODE ERROR DETECTING AND CORRECTING CIRCUIT

29　OUTER CODE ERROR DETECTING AND CORRECTING CIRCUIT

60　ERROR CORRECTING CIRCUIT

601　MEMORY CONTROL CIRCUIT

602　MEMORY

603　COUNTER

604　SELECTOR

605　SUBTRACTING CIRCUIT

606　BLOCK ID DETECTING CIRCUIT

607　JUDGING CIRCUIT

608　ERROR FLAG GENERATING CIRCUIT

609　ADDRESS GENERATING CIRCUIT

610　ERROR FLAG MEMORY

## Claims

1. An information transmission system for converting coded data in the form of an NRZL code into an NRZI code and transmitting the NRZI code together with identification data of a predetermined data pattern, comprising:

   an NRZI converting circuit (40; 306) for NRZI converting the coded data but outputting the identification data as they are without NRZI converting the same; characterized in that said NRZI converting circuit (40) further comprises: a latch circuit (410) for latching the last bit (b18) of the identification data of an output of said NRZI converting circuit;
   said NRZI converting circuit NRZI converting the coded data using, as an initial value for the NRZI data to be output, the output data of said latch circuit latched in a previous NRZL to NRZI conversion cycle.

2. An information transmission system according to claim 1, wherein the coded data inputted to said NRZI converting circuit has an m-bit parallel construction, and said NRZI converting circuit (40; 306) NRZI converts the coded data of the m-bit parallel construction in a parallel state.

3. An information transmission system according to claim 2, wherein said NRZI converting circuit (306) includes a ROM (306) from which a signal of a parallel construction obtained by NRZI conversion of the coded data is outputted when an address is designated by the coded data and output data of said latch circuit (410).

4. An information transmission system according to claim 2, wherein said NRZI converting circuit includes a number of exclusive OR circuits (401-409) equal to the bit number m of the coded data and a D flipflop (410), one of bit data of the m bits of NRZL format encoded data being inputted to one of a pair of input terminals of each of said exclusive OR circuits while an output signal of an adjacent one of said exclusive OR circuits to which a lower adjacent one of the bit data is inputted is inputted to the other input terminal of each of said exclusive OR circuits except that one (401) of said exclusive OR circuits to which the least significant bit data are inputted and to the other input terminal of which an output signal of that one (409) of said exclusive OR circuits to which the most significant bit data are inputted, is inputted by way of said D flipflop (410), whereby a signal in a parallel state obtained by NRZI conversion of the coded data is outputted from said m exclusive OR circuits (Fig. 9).

5. An information transmission system according to claim 2, wherein said NRZI converting circuit includes a parallel to serial converting circuit (308) for converting NRZI converted data of a parallel construction $DT_{NRZI}$ into data of a serial construction ($DS_{NRZI}$).

6. An information transmission system according to any one of claims 1 to 5 for coding n-bit information data in the form of an NRZL code into m-bit coded data such that only one information data corresponds to one of coded data which are all different from one another, n being greater than 2, m being greater than n, said system NRZI converting the coded data such that the DSV of a waveform of a thus NRZI converted signal and coded data having a CDS which does not have the same polarity as the DSV is selected as a next conversion output to limit the DSV of the NRZI converted signal and transmitting the thus NRZI converted coded data; said system further comprising:

   first controlling means for forming a control signal to control execution of the NRZI conversion of inputted information data and for forming a mode signal representative of a conversion mode;
   code generating means, for generating identification data having a predetermined data pattern and coded data obtained by such coding of the inputted information data in response to the mode signal outputted from said first controlling means and a coding control signal;
   CDS generating means for generating a CDS corresponding to an output code of said code generating means in response to the mode signal outputted from said first controlling means and the coding control signal;
   said NRZI converting means being responsive to the control signal outputted from said first controlling means for outputting the identification data outputted from said code generating means as they are without NRZI converting the same but for executing NRZI conversion of the coded data outputted from said code generating means using a value set with a conversion initial value signal as an initial value;

DSV detecting means for detecting a DSV corresponding to an output signal of said NRZI converting means in response to the conversion initial value signal outputted from said CDS generating means and a DSV immediately preceding to the DSV; and

second controlling means for generating the coding control signal in response to the control signal from said first controlling means, an output of said CDS generating means, the conversion initial value signal and an output of said DSV detecting means to limit the DSV of the output signal of said NRZI converting means.

7. An information transmission system according to claim 6, wherein said code generating means includes a first ROM in which the coded data and identification data are arranged and from which the coded data and identification data are outputted when an address is designated by the input information data, the mode signal and the coding control signal.

8. An information transmission system according to claim 6, wherein said CDS generating means includes a second ROM in which the coded word and a code of a CDS corresponding to the identification data are arranged and from which the code of the CDS is outputted when an address is designated by the input information data, the mode signal and the coding control signal.

9. An information transmission system according to claim 6, wherein said DSV detecting means includes a calculating circuit for adding or subtracting an output of said CDS generating means to or from the immediately preceding DSV in response to the conversion initial value signal, and a storage circuit for temporarily storing an output of said calculating circuit therein.

10. An information transmission system according to claim 6, wherein the polarities of the CDS and the DSV are all reversed, and only the most significant bit of an output of said calculating means of said DSV detecting means is used as DSV data.

11. An information recording device for converting coded data in the form of an NRZL code into an NRZI code and recording the NRZI code together with identification data of a predetermined data pattern, comprising:

an NRZI converting circuit (40; 306) for NRZI converting the coded data but outputting the identification data as they are without NRZI converting the same;

characterized in that said NRZI converting circuit (40) further comprises:

a latch circuit (410) for latching the last bit (b18) of the identification data of an output of said NRZI converting circuit:

said NRZI converting circuit NRZI converting the coded data using, as an initial value for the NRZI data to be output, the output data of said latch circuit latched in a previous NRZL to NRZI conversion cycle, an output signal of said NRZI converting circuit being recorded onto a record medium.

12. An information recording device according to claim 11, wherein the coded data inputted to said NRZI converting circuit has an m-bit parallel construction and said NRZI converting circuit (40; 306) NRZI converts the coded data of the m-bit parallel construction in a parallel state.

13. An information recording device according to claim 12, wherein said NRZI converting circuit (306) includes a ROM (306) from which a signal of a parallel construction obtained by NRZI conversion of the coded data is outputted when an address is designated by the coded data and output data of said latch circuit (410).

14. An information recording device according to claim 12, wherein said NRZI converting circuit includes a number of exclusive OR circuits (401-409) equal to the bit number m of the coded data and a D flipflop (410), one of bit data of the m bits of NRZL format encoded data being inputted to one of a pair of input terminals of each of said exclusive OR circuits while an output signal of an adjacent one of said exclusive OR circuits to which a lower adjacent one of the bit data is inputted is inputted to the other input terminal of each of said exclusive OR circuits, except that one (401) of said exclusive OR circuits to which the least significant bit data are inputted and to the other input terminal of which an output signal of that one (409) of said exclusive OR circuits to which the most significant bit data are inputted is inputted by way of said D flipflop (410), whereby a signal in a parallel state obtained by NRZI conversion of the coded data is outputted from said m exclusive OR circuits (Fig. 9).

15. An information recording device according to claim 12, wherein said NRZI converting circuit includes a parallel to serial converting circuit (308) for converting NRZI converted data of a parallel construction

$DT_{NRZI}$ into data of a serial construction ($DS_{NRZI}$).

16. An information recording device according to any one of claims 11 to 15, further comprising a device, correcting processing of reproduction data obtained from such record medium to reproduce data recorded on the record medium, comprising:

inner code error detecting and correcting means for detecting an inner code error of the transmission data, correcting the thus detected inner code error and outputting inner code correction data of a predetermined block data unit; memory means for storing the inner code correction data therein; counting means for counting the inner code correction data for each one block data as a unit; identification data detecting means for detecting identification data of one of the block data of the inner code correction data which are free from an error or have been corrected to eliminate an error; offset detecting means for detecting an offset amount between output data of said counting means and output data of said identification data detecting means: adding means for adding the output data of said identification data detecting means and output data of said offset detecting means and setting data obtained by such addition as preset data for said counting means; monitoring means for monitoring a continuity or the block data in accordance with output data of said counting means and output data of said identification data detecting means as well as an error flag developed from said inner code error detecting and correcting means and for judging whether or not the block data are correct block data depending upon a result of the monitoring; data selecting means for receiving the output data of said counting means and the output data of said identification data detecting means and for selecting either one of the output data of said counting means and the output data of said identification data detecting means as an output signal in response to an output signal of said monitoring means; address generating means for generating address data with which the inner code correction data are to be written into said memory means in response to output data of said data selecting means; and outer code error detecting and correcting means for reading out data stored in said memory means in accordance with a series of outer codes using offset data outputted from said offset detecting means, detecting an outer code error of the data thus read out and correcting the outer code error thus detected.

## Patentansprüche

1. Informationsübertragungssystem zum Umwandeln von kodierten Daten in Form eines NRZL-Codes in einen NRZI-Code und zum Übertragen des NRZI-Codes zusammen mit Identifizierungsdaten eines vorbestimmten Datenmusters,

mit einer NRZI-Umwandlungsschaltung (40; 306) zur NRZI-Umwandlung der kodierten Daten, wobei die genannten Identifizierungsdaten jedoch ohne NRZI-Umwandlung so ausgegeben werden, wie sie sind,

dadurch gekennzeichnet,

daß die NRZI-Umwandlungsschaltung (40) ferner aufweist:

eine Halteschaltung (410) zum Halten des letzten Bits (b18) der Identifizierungsdaten des Ausgangssignals der NRZI-Umwandlungsschaltung, wobei die NRZI-Umwandlungsschaltung die NRZI-Umwandlung der kodierten Daten unter Verwendung der in einem vorangehenden NRZL/NRZI-Umwandlungszyklus gehaltenen Ausgangsdaten der Halteschaltung als Anfangswert für die auszugebenden NRZI-Daten vornimmt.

2. Informationsübertragungssystem nach Anspruch 1, bei dem die der NRZI-Umwandlungsschaltung zugeführten kodierten Daten einen parallelen m-Bit-Aufbau haben und die NRZI-Umwandlungsschaltung (40; 306) die kodierten Daten mit parallelem m-Bit-Aufbau im parallelen Status der NRZI-Umwandlung unterzieht.

3. Informationsübertragungssystem nach Anspruch 1, bei dem die NRZI-Umwandlungsschaltung (306) ein ROM (306) aufweist, aus dem ein durch NRZI-Umwandlung der kodierten Daten gewonnenes Signal mit parallelem Aufbau ausgegeben wird, wenn aus den kodierten Daten und den Ausgangsdaten der Halteschaltung (410) eine Adresse bestimmt wird.

4. Informationsübertragungssystem nach Anspruch 2, bei dem die NRZI-Umwandlungsschaltung eine der Bitzahl m der kodierten Daten entsprechende Zahl von Exklusiv-ODER-Schaltungen (401 bis 409) und ein D-Flipflop (410) aufweist, einem von zwei Eingängen jeder der Exklusiv-ODER-Schaltungen jeweils eine der Bitdaten der m Bits der im NRZL-Format kodierten Daten zugeführt wird, während dem jeweils anderen Eingang jeder Exklusiv-ODER-Schaltung das Ausgangssignal einer benachbarten Exklusiv-ODER-Schaltung zugeführt wird, der ein benachbartes niedrigerwertiges Exemplar der Bitdaten zugeführt wird, mit Ausnahme derjenigen Exklusiv-ODER-Schaltung (401), der die niedrigstwertigen Bitdaten zugeführt werden und deren anderem Eingang über das genannte D-Flipflop (410) das Ausgangssignal derjenigen Exklusiv-ODER-Schaltung (409) zugeführt wird, der die höchstwertigen Bitdaten zugeführt werden, so daß von den m Exklusiv-ODER-Schaltungen ein durch NRZI-Umwandlung der kodierten Daten gewonnenes paralleles Signal ausgegeben wird (Fig. 11).

5.  Informationsübertragungssystem nach Anspruch 2, bei dem die NRZI-Umwandlungsschaltung eine Parallel/Serien-Wandlerschaltung (308) aufweist zur Umwandlung der NRZI-gewandelten Daten mit parallelem Aufbau ($DS_{NRZI}$) in Daten mit seriellem Aufbau.

6.  Informationsübertragungssystem nach einem der Ansprüche 1 bis 5 zum Kodieren von n-Bit-Informationsdaten in Form eines NRZL-Codes in m-Bit-kodierte Daten derart, daß nur eine der Informationsdaten nur einer der kodierten Daten entspricht, die alle voneinander verschieden sind, wobei n größer ist als 2 und m größer ist als n,

    wobei das System

    die kodierten Daten derart NRZI-wandelt, daß als nächstes Umwandlungs-Ausgangssignal die Digitalsummen-Variation (DSV) der Wellenform eines auf diese Weise NRZI-gewandelten Signals und die kodierten Daten mit einer Codewort-Digitalsumme (CDS), die nicht die gleiche Polarität hat wie die DSV, ausgewählt wird, um die DSV des NRZI-gewandelten Signals zu begrenzen, und die auf diese Weise NRZI-gewandelten kodierten Daten überträgt,

    wobei das System ferner aufweist:

    eine erste Steuereinrichtung zur Bildung eines Steuersignals für die Steuerung der NRZI-Umwandlung von eingegebenen Identifizierungsdaten und zur Bildung eines Modussignals, das für einen Umwandlungsmodus kennzeichnend ist, eine Codeerzeugungseinrichtung zum Erzeugen von Identifizierungsdaten mit einem vorbestimmten Datenmuster und von kodierten Daten, die durch eine solche Kodierung der zugeführten Informationsdaten gewonnen werden, in Abhängigkeit von dem von der ersten Steuereinrichtung ausgegebenen Modussignal und einem Kodierungssteuersignal,

eine CDS-Erzeugungseinrichtung zum Erzeugen einer einem Ausgangscode der Codeerzeugungseinrichtung entsprechenden CDS in Abhängigkeit von dem von der ersten Steuereinrichtung ausgegebenen Modussignal und dem Kodierungssteuersignal, wobei die NRZI-Umwandlungseinrichtung auf das von der ersten Steuereinrichtung ausgegebene Steuersignal anspricht, um die von der Codeerzeugungseinrichtung ausgegebenen Informationsdaten ohne NRZI-Umwandlung so auszugeben, wie sie sind, die von der Codeerzeugungseinrichtung ausgegebenen kodierten Daten jedoch einer NRZI-Umwandlungseinrichtung zu unterziehen unter Verwendung eines mit einem Umwandlungsanfangswertsignal gesetzten Wert als Anfangswert, eine DSV-Detektoreinrichtung zum Detektieren einer einem Ausgangssignal der NRZI-Umwandlungseinrichtung entsprechenden DSV in Abhängigkeit von einem von der DSV-Erzeugungseinrichtung ausgegebenen Umwandlungsanfangswertsignals und einer der DSV unmittelbar vorangehenden DSV und eine zweite Steuereinrichtung zur Erzeugung des Kodierungssteuersignal in Abhängigkeit von dem Steuersignal aus der ersten Steuereinrichtung, einem Ausgangssignal der CDS-Erzeugungseinrichtung, dem Umwandlungsanfangswertsignal und einem Ausgangssignal der DSV-Detektoreinrichtung zum Begrenzen der DSV des Ausgangssignals der NRZI-Umwandlungseinrichtung.

7.  Informationsübertragungssystem nach Anspruch 6, bei dem die Codeerzeugungseinrichtung ein erstes ROM aufweist, in dem die kodierten Daten und Identifizierungsdaten angeordnet sind und aus dem die kodierten Daten und die Identifizierungsdaten ausgegeben werden, wenn durch die Eingangsinformationsdaten, das Modussignal und das Kodierungssteuersignal eine Adresse bestimmt wird.

8.  Informationsübertragungssystem nach Anspruch 6, bei dem die CDS-Erzeugungseinrichtung ein zweites ROM aufweist, in dem das kodierte Wort und ein Code einer den Identifizierungsdaten entsprechenden CDS angeordnet sind und aus der der Code der CDS ausgeben wird, wenn durch die Eingangsinformationsdaten, das Modussignal und das Kodierungssteuersignal eine Adresse bestimmt wird.

9.  Informationsübertragungssystem nach Anspruch 6, bei dem die DSV-Detektoreinrichtung eine Rechenschaltung enthält zum Addieren oder Subtrahieren des Ausgangssignals der CDS-Erzeugungseinrichtung zu der bzw. von der unmittelbar vorhergehenden DSV in Ahhängigkeit von dem Umwandlungsanfangswertsignal, sowie eine Speicherschaltung zur temporären Speicherung des Ausgangssignals der Rechenschaltung.

10. Informationsübertragungssystem nach Anspruch 6, bei dem alle Polaritäten der CDS und der DSV umgekehrt werden und nur das höchstwertige Bit des Ausgangssignals der Rechenschaltung der DSV-Detektoreinrichtung als DSV-Daten verwendet wird.

11. Informationsaufzeichnungsvorrichtung zur Umwandlung kodierter Daten in Form eines NRZL-Codes in einen NRZI-Code und zum Aufzeichnen des NRZI-Codes zusammen mit Identifizierungsdaten eines vorbestimmten Datenmusters, bestehend aus

einer NRZI-Umwandlungsschaltung (40; 306) zur NRZI-Umwandlung der kodierten Daten, wobei die genannten Identifizierungsdaten jedoch ohne NRZI-Umwandlung so ausgegeben werden, wie sie sind,

dadurch gekennzeichnet,

daß die NRZI-Umwandlungsschaltung (40) ferner aufweist:

eine Halteschaltung (410) zum Halten des letzten Bits (b18) der Identifizierungsdaten des Ausgangssignals der NRZI-Umwandlungsschaltung,

wobei das Ausgangssignal der NRZI-Umwand-lungsschaltung auf einem Aufzeichnungsmedi-um aufgezeichnet wird.

12. Informationsaufzeichnungsvorrichtung nach Anspruch 11, bei dem die der NRZI-Umwandlungsschaltung zugeführten kodierten Daten einen parallelen m-Bit-Aufbau haben und die NRZI-Umwandlungsschaltung (40; 306) die kodierten Daten mit parallelem m-Bit-Aufbau im parallelen Status der NRZI-Umwandlung unterzieht.

13. Informationsaufzeichnungsvorrichtung nach Anspruch 12, bei dem die NRZI-Umwandlungsschaltung (306) ein ROM (306) aufweist, aus dem ein durch NRZI-Umwandlung der kodierten Daten gewonnenes Signal mit parallelem Aufbau ausgegeben wird, wenn aus den kodierten Daten und den Ausgangsdaten der Halteschaltung (410) eine Adresse bestimmt wird.

14. Informationsaufzeichnungsvorrichtung nach Anspruch 12, bei dem die NRZI-Umwandlungsschaltung eine der Bitzahl m der kodierten Daten entsprechende Zahl von Exklusiv-ODER-Schaltungen (401 bis 409) und ein D-Flipflop (410) aufweist, einem von zwei Eingängen jeder der Exklusiv-ODER-Schaltungen jeweils eine der Bitdaten der m Bits der im NRZL-Format kodierten Daten zugeführt wird, während dem jeweils anderen Eingang jeder Exklusiv-ODER-Schaltung das Ausgangssignal einer benachbarten Exklusiv-ODER-Schaltung zugeführt wird, der ein benachbartes niedrigerwertiges Exemplar der Bitdaten zugeführt wird, mit Ausnahme derjenigen Exklusiv-ODER-Schaltung (401), der die niedrigstwertigen Bitdaten zugeführt werden und deren anderem Eingang über das genannte D-Flipflop (410) das Ausgangssignal derjenigen Exklusiv-ODER-Schaltung (409) zugeführt wird, der die höchstwertigen Bitdaten zugeführt werden, so daß von den m Exklusiv-ODER-Schaltungen ein durch NRZI-Umwandlung der kodierten Daten gewonnenes paralleles Signal ausgegeben wird (Fig. 11).

15. Informationsaufzeichnungsvorrichtung nach Anspruch 12, bei dem die NRZI-Umwandlungsschaltung eine Parallel/Serien-Wandlerschaltung (308) aufweist zur Umwandlung der NRZI-gewandelten Daten mit parallelem Aufbau ($DS_{NRZI}$) in Daten mit seriellem Aufbau.

16. Informationsaufzeichnungsvorrichtung nach einem der Ansprüche 11 bis 15, ferner mit einer Vorrichtung zum Korrigieren der von dem Aufzeichnungs-medium gewonnenen Wiedergabedaten zum Re-produzieren von auf dem Aufzeichnungsmedium aufgezeichneten Daten mit

einer Innencode-Fehlerdetektor- und -korrek-tureinrichtung zum Detektieren einen Innenco-defehlers der Übertragungsdaten, zum Korri-gieren des so detektierten Innencodefehlers und zur Ausgabe von Innencodekorrekturdaten einer vorbestimmten Blockdateneinheit, einer Speichereinrichtung zur Speicherung der Innencodekorrekturdaten, einer Zähleinrichtung zum Zählen der Innencodekorrekturdaten für jeweils ein Exemplar der Blockdaten als Einheit, einer Identifizierungsdaten-Detektoreinrich-tung zum Detektieren von Identifizierungsda-ten eines Exemplars der Blockdaten der Innencode-Korrekturdaten, die fehlerfrei sind oder korrigiert wurden, um einen Fehler zu eliminieren, einer Offset-Detektoreinrichtung zum Detektieren eines Offsetgröße zwischen den Ausgangsdaten der Zähleinrichtung und den Aus-gangsdaten der Identifizierungsdaten-Detek-toreinrichtung, einer Addiereinrichtung zum Addieren der Aus-gangsdaten der Identifizierungsdaten-Detek-toreinrichtung und der Ausgangsdaten der Offset-Detektoreinrichtung und zum Setzen der durch die Addition gewonnenen Daten als Voreinstelldaten für die Zähleinrichtung,

einer Überwachungseinrichtung zur Überwachung der Kontinuität der Blockdaten nach Maßgabe der Ausgangsdaten der Zähleinrichtung und der Ausgangsdaten der Identifizierungsdaten-Detektoreinrichtung und eines von der Innencode-Fehlerdetektor- und -Korrektureinrichtung entwickelten Fehlerflags sowie für die in Abhängigkeit von dem Ergebnis der Überwachung erfolgende Beurteilung, ob die Blockdaten korrekte Blockdaten sind oder nicht,

einer Datenauswahleinrichtung zur Aufnahme der Ausgangsdaten der Zähleinrichtung und der Ausgangsdaten der Identifizierungsdaten-Detektoreinrichtung und zur Auswahl entweder der Ausgangsdaten der Zähleinrichtung oder der Ausgangsdaten der Identifizierungsdaten-Detektoreinrichtung als Ausgangssignal in Abhängigkeit von dem Ausgangssignal der Überwachungseinrichtung,

einer Adressenerzeugungseinrichtung zur Erzeugung von Adressendaten, mit denen die Innencode-Korrekturdaten in die genannten Speichereinrichtung einzuschreiben sind, in Abhängigkeit von den Ausgangsdaten der Auswahleinrichtung, und

einer Außencode-Fehlerdetektor- und -korrektureinrichtung zum Auslesen von in der Speichereinrichtung gespeicherten Daten nach Maßgabe einer Serie von Außencodes unter Verwendung der von der Offset-Detektoreinrichtung ausgegebenen Offsetdaten zum Detektieren eines Außencodefehler der so ausgelesenen Daten und zum Korrigieren des so detektierten Außencodefehlers.

## Revendications

1. Système de transmission d'informations servant à convertir des données codées qui se présentent sous la forme d'un code NRZL en un code NRZI et à transmettre le code NRZI en même temps que des données d'identification d'une configuration de données prédéterminée, comprenant:

un circuit de conversion NRZI (40 ; 306) servant à appliquer la conversion NRZI aux données codées, mais délivrant les données d'identification telles qu'elles sont sans leur appliquer la conversion NRZI ;

caractérisé en ce que ledit circuit (40) de conversion NRZI comprend en outre :

un circuit de verrouillage (410) servant à verrouiller le dernier bit ($b_{18}$) des données d'identification d'un signal de sortie dudit circuit de conversion NRZI ;

ledit circuit de conversion NRZI effectuant la conversion NRZI des données codées en utilisant, comme valeur initiale pour les données NRZI à délivrer, les données de sortie dudit circuit de verrouillage verrouillées lors d'un précédent cycle de conversion NRZL en NRZI.

2. Système de transmission d'informations selon la revendication 1, où les données codées appliquées en entrée audit circuit de conversion NRZI présentent une structure parallèle à m bits, et ledit circuit (40 ; 306) de conversion NRZI applique la conversion NRZI aux données codées de la structure parallèle à m bits dans un état parallèle.

3. Système de transmission d'informations selon la revendication 2, où ledit circuit (306) de conversion NRZI comporte une ROM (306) de laquelle est délivré un signal d'une structure parallèle qui est obtenu par la conversion NRZI des données codées lorsqu'une adresse est désignée par les données codées et les données de sortie dudit circuit de verrouillage (410).

4. Système de transmission d'informations selon la revendication 2, où ledit circuit de conversion NRZI comporte un nombre de circuits OU exclusif (401-409) égal au nombre m de bits des données codées et une bascule D (410), l'une des données de bits des m bits des données codées dans le format NRZL étant appliquée en entrée à une borne d'une paire de bornes d'entrée de chacun desdits circuits OU exclusif tandis qu'un signal de sortie d'un circuit adjacent parmi lesdits circuits OU exclusif auquel une donnée de bit adjacente inférieure des données de bits est appliquée en entrée, est appliqué en entrée à l'autre borne d'entrée de chacun desdits circuits OU exclusif à l'exception de celui (401) desdits circuits OU exclusif auquel la donnée de bit de moindre signification est appliquée et à l'autre borne d'entrée duquel le signal de sortie de celui (409) desdits circuits OU exclusif auquel la donnée de bit de plus grande signification est appliquée en entrée, est appliqué en entrée via ladite bascule D (410), de sorte qu'un signal se trouvant dans un état parallèle et qui est obtenu par la conversion NRZI des données codées est délivré par lesdits m circuits OU exclusif (Figure 9).

5. Système de transmission d'informations selon la revendication 2, où ledit circuit de conversion NRZI comporte un circuit (308) de conversion de la forme parallèle à la forme série, servant à convertir des données ayant subi la conversion NRZI et ayant une structure parallèle ($DT_{NRZI}$) en des données ayant une structure série ($DS_{NRZI}$).

**6.** Système de transmission d'informations selon l'une quelconque des revendications 1 à 5, servant à coder des données d'informations à n bits se présentant sous la forme d'un code NRZL en des données codées à m bits de façon que seule une donnée d'informations corresponde à une des données codées, lesquelles sont toutes différentes les unes des autres, n étant supérieur à 2, m étant plus grand que n, ledit système effectuant la conversion NRZI des données codées de façon que le DSV d'une forme d'onde d'un signal ainsi converti à la forme NRZI et de données codées ayant un CDS qui ne possède pas la même polarité que le DSV soit sélectionné comme signal de sortie de conversion suivant afin de limiter le DSV du signal ayant subi la conversion NRZI et transmettant les données codées ayant ainsi subi la conversion NRZI ; ledit système comprenant en outre :

un premier moyen de commande servant à former un signal de commande pour commander l'exécution de la conversion NRZI de données d'informations appliquées en entrée et à former un signal de mode représentatif d'un mode de conversion ;

un moyen générateur de codes, servant à produire des données d'identification ayant une configuration de données prédéterminée et des données codées obtenues par ce codage des données d'informations appliquées, en fonction du signal de mode délivré par ledit premier moyen de commande et d'un signal de commande de codage ;

un moyen générateur de CDS servant à produire un CDS qui correspond à un code de sortie dudit moyen générateur de codes, en fonction du signal de mode délivré par ledit premier moyen de commande et du signal de commande de codage ;

ledit moyen de conversion NRZI répondant au signal de commande délivré par ledit premier moyen de commande en délivrant les données d'identification délivrées par ledit moyen générateur de codes telles qu'elles sont, sans leur appliquer la conversion NRZI, mais en exécutant la conversion NRZI des données codées délivrées par ledit moyen générateur de code à l'aide d'un ensemble de valeurs ayant comme valeur initiale un signal de valeur initiale de conversion ;

un moyen de détection de DSV servant à détecter un DSV qui correspond à un signal de sortie dudit moyen de conversion NRZI, en fonction du signal de valeur initiale de conversion délivré par ledit moyen générateur de CDS et d'un DSV précédant immédiatement le DSV ; et

un deuxième moyen de commande servant à produire le signal de commande de codage en fonction du signal de commande venant dudit premier moyen de commande, d'un signal de sortie dudit moyen générateur de CDS, du signal de valeur initiale de conversion et d'un signal de sortie dudit moyen de détection de DSV, afin de limiter le DSV du signal de sortie dudit moyen de conversion NRZI.

**7.** Système de transmission d'informations selon la revendication 6, où ledit moyen générateur de codes comporte une première ROM dans laquelle les données codées et les données d'identification sont disposées et en provenance de laquelle les données codées et les données d'identification sont délivrées lorsqu'une adresse est désignée par les données d'informations d'entrée, le signal de mode et le signal de commande de codage.

**8.** Système de transmission d'informations selon la revendication 6, où ledit moyen générateur de CDS comporte une deuxième ROM dans laquelle le mot codé et un code d'un CDS correspondant aux données d'identification sont disposés et en provenance de laquelle le code du CDS est délivré lorsqu'une adresse est désignée par les données d'informations d'entrée, le signal de mode et le signal de commande de codage.

**9.** Système de transmission d'informations selon la revendication 6, où ledit moyen de détection de DSV comporte un circuit de calcul servant à ajouter ou soustraire un signal de sortie dudit moyen générateur de CDS au DSV immédiatement précédent, en fonction du signal de valeur initiale de conversion, et un circuit de mémoire servant à mémoriser temporairement un signal de sortie dudit circuit de calcul.

**10.** Système de transmission d'informations selon la revendication 6, où les polarités des CDS et des DSV sont toutes inversées, et seul le bit de plus grande signification d'un signal de sortie dudit moyen de calcul dudit moyen de détection de DSV est utilisé comme donnée de DSV.

**11.** Dispositif d'enregistrement d'informations servant à convertir des données codées se présentant sous la forme d'un code NRZL en un code NRZI et à enregistrer le code NRZI en même temps que des données d'identification d'une configuration de données prédéterminée, comprenant:

un circuit de conversion NRZI (40 ; 306) servant à effectuer la conversion NRZI des données codées, mais délivrant les données d'identification telles qu'elles sont, sans leur appliquer de conversion NRZI ;

caractérisé en ce que ledit circuit de conversion NRZI (40) comprend en outre :

un circuit de verrouillage (410) servant à verrouiller le dernier bit ($b_{18}$) des données d'identification d'un signal de sortie dudit circuit de conversion NRZI ;
ledit circuit de conversion NRZI appliquant la conversion NRZI aux données codées en utilisant, comme valeur initiale pour les données NRZI à délivrer, les données de sortie dudit circuit de verrouillage verrouillées lors d'un précédent cycle de conversion NRZL en NRZI, un signal de sortie dudit circuit de conversion NRZI étant enregistré sur un support d'enregistrement.

12. Dispositif d'enregistrement d'informations selon la revendication 11, où les données codées appliquées en entrée audit circuit de conversion NRZI présentent une structure parallèle à m bits, et ledit circuit (40 ; 306) de conversion NRZI applique la conversion NRZI aux données codées de la structure parallèle à m bits dans un état parallèle.

13. Dispositif d'enregistrement d'informations selon la revendication 12, où ledit circuit (306) de conversion NRZI comporte une ROM (306) depuis laquelle est délivré un signal d'une structure parallèle obtenue par la conversion NRZI des données codées lorsqu'une adresse est désignée par les données codées et les données de sortie dudit circuit de verrouillage (410).

14. Dispositif d'enregistrement d'informations selon la revendication 12, où ledit circuit de conversion NRZI comporte un nombre de circuits OU exclusif (401-409) égal au nombre m de bits des données codées et une bascule D (410), l'une des données de bits des m bits des données codées dans le format NRZL étant appliquée en entrée à une borne d'une paire de bornes d'entrée de chacun desdits circuits OU exclusif tandis qu'un signal de sortie d'un circuit adjacent parmi lesdits circuits OU exclusif auquel une donnée de bit adjacente inférieure des données de bits est appliquée en entrée, est appliqué en entrée à l'autre borne d'entrée de chacun desdits circuits OU exclusif à l'exception de celui (401) desdits circuits OU exclusif auquel la donnée de bit de moindre signification est appliquée et à l'autre borne d'entrée duquel le signal de sortie de celui (409) desdits circuits OU exclusif auquel la donnée de bit de plus grande signification est appliquée en entrée, est appliqué en entrée via ladite bascule D (410), de sorte qu'un signal se trouvant dans un état parallèle et qui est obtenu par la conversion NRZI des données codées est délivré par lesdits m circuits OU exclusif (Figure 9).

15. Dispositif d'enregistrement d'informations selon la revendication 12, où ledit circuit de conversion NRZI comporte un circuit (308) de conversion de la forme parallèle à la forme série, servant à convertir des données ayant subi la conversion NRZI et ayant une structure parallèle ($DT_{NRZI}$) en des données ayant une structure série ($DS_{NRZI}$).

16. Dispositif d'enregistrement d'informations selon l'une quelconque des revendications 11 à 15, comprenant en outre un dispositif corrigeant le traitement de données de reproduction obtenues de ce support d'enregistrement pour reproduire les données enregistrées sur le support d'enregistrement, comprenant :

un moyen de détection et de correction d'erreurs de code interne servant à détecter une erreur de code interne des données de transmission, à corriger l'erreur de code interne ainsi détectée et à délivrer des données de correction de code interne d'une unité de données de bloc prédéterminée ;
un moyen de mémoire servant à stocker les données de correction de code interne ;
un moyen de comptage servant à compter les données de correction de code interne pour chaque donnée de bloc comme unité ;
un moyen de détection de données d'identification servant à détecter des données d'identification de l'une des données de bloc des données de correction de code interne qui sont dépourvues d'erreur ont été corrigées pour éliminer une erreur ;
un moyen de détection de décalage servant à détecter une amplitude de décalage entre des données de sortie dudit moyen de comptage et des données de sortie dudit moyen de détection de données d'identification ;
un moyen d'addition servant à additionner les données de sortie dudit moyen de détection de données d'identification et les données de sortie dudit moyen de détection de décalage et à fixer les données obtenues par cette addition comme données de prépositionnement dudit moyen de comptage ;
un moyen de contrôle servant à contrôler la continuité des données de bloc en fonction des données de sortie dudit moyen de comptage et des données de sortie dudit moyen de détection de données d'identification, ainsi qu'en fonction d'un drapeau d'erreur produit par ledit moyen de détection et de correction d'erreurs de code interne, et à décider si les données de bloc sont ou non des données de bloc correctes, selon le résultat du contrôle ;
un moyen de sélection de données servant à recevoir les données de sortie dudit moyen de comptage et les données de sortie dudit moyen de détection de données d'identification et à sélectionner les données de sortie dudit moyen de comptage ou bien les données de sortie dudit moyen de détection de données d'identification comme signal de sortie en réponse à un signal de sortie dudit moyen de contrôle ;

un moyen générateur d'adresse servant à produire des données d'adresse avec lesquelles les données de correction de code interne doivent être écrites dans ledit moyen de mémoire en réponse à des données de sortie dudit moyen de sélection de données ; et

un moyen de détection et de correction d'erreurs de code externe servant à lire les données mémorisées dans ledit moyen de mémoire en fonction d'une série de codes externes utilisant les données de décalage qui sont délivrées par ledit moyen de détection de décalage, à détecter une erreur de code externe des données ainsi lues, et à corriger l'erreur de code externe ainsi détectée.

# FIG. 1

14 MAGNETIC TAPE

DATA TRACK

ANN  --- TR1 TR2 TR3 TR4 ---

CTL

TC·

EP 0 415 853 B1

# FIG. 2

SEC SECTOR (TR RECORD TRACK)

EP 0 415 853 B1

EP 0 415 853 B1

# FIG. 3

1 RECORDING SYSTEM

15 MAGNETIC TAPE
16 MAGNETIC HEAD

DT$_{USE}$    DO    DI

| OUTER CODE GENERATING CIRCUIT | MUX | MEMORY | INNER CODE GENERATING CIRCUIT | MUX | DATA RANDOMIZING CIRCUIT | 8—9 MODULATING CIRCUIT | MUX | PARALLEL/ SERIAL CONVERTING CIRCUIT | RECORDING AND AMPLIFYING CIRCUIT |

2    3    4    6    7    9    10    11    13    14

S$_{REC}$

ID$_B$    PR,PS    SYNC$_B$

DT$_{AUX}$

IDENTIFICATION DATA GENERATING CIRCUIT

PREAMBLE PORTION DATA POSTAMBLE CIRCUIT

SYNCHRONIZATION CODE GENERATING CIRCUIT

5    8    12

# FIG. 4

DO (OUTER DATA BLOCK)

118 BYTES      10 BYTES

| DTUSE | RO |
|---|---|

SOURCE DATA      OUTER ERROR CODE

EP 0 415 853 B1

# FIG. 5

MEM 1

MEM 2

1 BYTE BLOCK ID

153 BYTE SOURCE DATA

118 BYTES SOURCE DATA

10 BYTES OUTER ERROR CODE (RO)

| 00 | DI₀ |
| 02 | DI₂ |
| 04 | DI₄ |
| 06 | DI₆ |
| EB | DI₂₃₄ |
| ED | DI₂₃₆ |
| FA | DI₂₅₀ |
| FC | DI₂₅₂ |
| FE | DI₂₅₄ |

IDᵦ  DO₀ DO₁ DO₂     DO₁₅₀ DO₁₅₁ DO₁₅₂

| 01 | DI₁ |
| 03 | DI₃ |
| 05 | DI₅ |
| 07 | DI₇ |
| EC | DI₂₃₅ |
| EE | DI₂₃₇ |
| FB | DI₂₅₁ |
| FD | DI₂₅₃ |
| FF | DI₂₅₅ |

IDᵦ  DO₁₅₃ DO₁₅₄ DO₁₅₅     DO₃₀₃ DO₃₀₄ DO₃₀₅

EP 0 415 853 B1

# FIG. 6

DI (INNER DATA BLOCK)

BLOCK IDENTIFICATION DATA      SOURCE DATA      INNER ERROR CODE

EP 0 415 853 B1

# FIG. 7

**MAP 1**

SYNC
ID
SOURCE DATA
INNER ERROR CODE
OUTER ERROR CODE

4
1
153
8
118
10

**MAP 2**

SYNC
ID
SOURCE DATA
INNER ERROR CODE
OUTER ERROR CODE

8

PR 20

PS 8

UNIT : BYTE

# FIG. 8

15 MAGNETIC TAPE

16 MAGNETIC HEAD

DTPB  DTPR  DI

| REPRODUCING AND AMPLIFYING CIRCUIT (21) | SERIAL/PARALLEL CONVERTING CIRCUIT (22) | SYNCHRONIZATION CODE DETECTING CIRCUIT (23) | 8—9 DEMODULATING CIRCUIT (24) | DATA DERANDOMIZING CIRCUIT (25) | INNER CODE ERROR DETECTING AND CORRECTING CIRCUIT (26) |

SPB

IDENTIFICATION DATA DATA DETECTING (27) → MEMORY (28) → OUTER CODE ERROR DETECTING AND CORRECTING CIRCUIT (29) → DTuse

DO

EP 0 415 853 B1

# FIG. 9
## PRIOR ART

10  8-9 MODULATING CIRCUIT

EP 0 415 853 B1

# FIG. 10

30  8-9 MODULATING CIRCUIT

EP 0 415 853 B1

# FIG. II

EP 0 415 853 B1

## 40 NRZL/NRZI CONVERTING CIRCUIT

## FIG. 12

EP 0 415 853 B1

50 ERROR CORRECTING CIRCUIT

DTsec → | INNER CODE ERROR DETECTING AND CORRECTING | 26

MEMORY 502

OUTER CODE ERROR DETECTING AND CORRECTING | 29 → DTpb

ADRrow

Cmem

COUNTER 503

LAST ADDRESS DETECTING CIRCUIT 508

PST

CNT

OFF

BLOCK ID DETECTING CIRCUIT 504

IDblk

SUBTRACTING CIRCUIT 505

OFFSET DETECTING CIRCUIT 507

ADDING CIRCUIT 506

501 MEMORY CONTROL CIRCUIT

# FIG. 13

(A)

| ADR_ROW | ID_BLK MEM10 |
|---|---|
| O O | F D □(DT1■) |
| O 2 | F F □(DT3■) |
| O 4 | O 1 ■ |
| O 6 | O 3 □ |
| O 8 | O 5 ■ |
| O A | O 7 □ |
| | |
| F A | F 7 □ |
| F C | F 9 □ |
| F E | F B □ |

(B)

| ADR_ROW | ID_BLK MEM20 |
|---|---|
| O 1 | F E □(DT2■) |
| O 3 | O O ■ |
| O 5 | O 2 □ |
| O 7 | O 4 ■ |
| O 9 | O 6 ■ |
| O B | O 8 □ |
| | |
| F B | F 8 □ |
| F D | F A □ |
| F F | F C □ |

EP 0 415 853 B1

# FIG. 14

60 ERROR CORRECTING CIRCUIT

601 MEMORY CONTROL CIRCUIT

DTSEC

INNER CODE ERROR DETECTING AND CORRECTING — 26

CNT

RST

BLOCK ID DETECTING CIRCUIT — 606

IDBLK

SELECTOR — 604

ADDRESS GENERATING CIRCUIT — 609

CSEL

COUNTER — 603

SUBTRACTING CIRCUIT — 605

COUT

CLD

SB

JUDGING CIRCUIT — 607

CEF

ERROR FLAG GENERATING CIRCUIT — 608

ERROR FLAG MEMORY — 610

FLGIN

MEMORY — 602

ADRROWI

OUTER CODE ERROR DETECTING AND CORRECTING — 29

DTUSE

EP 0 415 853 B1

37